# EUROPEAN PATENT APPLICATION

(11) **EP 1 705 002 A1**
(43) Date of publication of application: **27.09.2006**
(21) Application number: 05028637.6
(22) Date of filing: 29.12.2005
(51) Int. Cl.: B41C 1/10, B41N 3/03

(54) **Planographic printing plate precursor and plate-making method thereof**

(30) Priority: 23.03.2005 JP 2005084675; 27.09.2005 JP 2005280812
(71) Applicant: FUJI PHOTO FILM CO., LTD., Minami-Ashigara-shi, Kanagawa (JP)
(72) Inventor: Koizumi, Shigeo, Yoshida-cho Haibara-gun Shizuoka-ken (JP)
(74) Representative: HOFFMANN EITLE

(57) **Abstract**

The planographic printing plate precursor according to the invention is a planographic printing plate precursor having a photosensitive layer containing an infrared absorbent, a polymerization initiator, a polymerizable compound, and a binder polymer and a protective layer formed in this order on a hydrophilic aluminum support surface, wherein the protective layer contains polyvinylalcohol having a saponification value of 91 mole % or more and a mica compound in an amount of 5 wt % to 50 wt % relative to the total weight of the protective layer.

## Description

### BACKGROUND OF THE INVENTION

### Field of the Invention

The invention relates to a negative planographic printing plate precursor capable of direct printing with infrared laser beam and high speed plate-making, and a plate-making method of producing a planographic printing plate allowing reliable development for an extended period of time.

### Description of the Related Art

PS plates having an oleophilic photosensitive resin layer formed on a hydrophilic support have been widely used as planographic printing plate precursors. The PS plates have been produced commonly by subjecting a mask exposure (surface exposure) of the photosensitive layer through a lith film and by dissolving and thus removing the non-image regions thereof. In recent years, digital technology, by which image information is processed, stored, and outputted electronically by computer, is becoming more and more popular. Accordingly, various newer image-output methods compatible with the digital technology have been commercialized. As a result, there is an urgent need for the "computer to plate (CTP) technology" that allows direct production of printing plates by scanning a high-directivity light such as laser beam according to digitalized image information without using the lith film, and thus for the planographic printing plate precursors that are compatible with the CTP technology.

As the planographic printing plate precursor compatible with such scanning exposure, a planographic printing plate precursor wherein an oleophilic photosensitive resin layer (hereinafter, referred to as photosensitive layer) containing a photosensitive compound that can generate an active species such as a radical, Bronsted acid, or the like by laser exposure is formed on a hydrophilic support was proposed and already commercialized. It is possible to obtain negative-type planographic printing plates by scanning the planographic printing plate precursor with a laser according to digital information, generating such active species and thus causing physical and chemical changes in the photosensitive layer, insolubilizing the exposed regions, and developing the images thereon.

In particular, a planographic printing plate precursor wherein a photopolymerizable photosensitive layer containing a photopolymerization initiator superior in sensitization speed, an addition-polymerizable ethylenic unsaturated compound, and a binder polymer soluble in alkaline developing solution, and additionally an oxygen-blocking protective layer as needed are formed on a hydrophilic support (see, for example, Japanese Patent Application Laid-Open (JP-A) No. 10-228109) is superior in productivity, easier in developing processing, and superior in resolution and inking property and is therefore a desirable printing plate precursor superior in printing properties.

For further improvement in productivity, i.e., in plate-making speed, a recording material that employs a photopolymerizable composition containing a cyanine dye having a particular structure, an iodonium salt and an addition polymerizable compound having ethylenic unsaturated double bonds as the photosensitive layer and that does not require heat treatment after image exposure (see, for example, Japanese Patent Application Publication (JP-B) No. 7-103171) has been proposed, but the recording material is susceptible to polymerization inhibition by oxygen in the air during the polymerization reaction and thus has problems that the sensitivity is lower and the strength of image portions formed in the image region is insufficient.

To overcome these problems, a method of forming a protective layer which contains a water-soluble polymer on a photosensitive layer and a method of forming a protective layer which contains an inorganic layered compound and a water-soluble polymer (see, for example, JP-A No. 11-38633) have been known. Presence of the protective layer enables prevention of the polymerization inhibition, acceleration of the curing reaction of photosensitive layer, and improvement in the intensity of image region.

On the other hand, reduction of the time needed in an exposure step is important for improving productivity in plate-making of a photopolymerizing planographic printing plate precursor that is easily developed. Normally, the planographic printing plate precursors are supplied in the exposure step as a laminate containing between the precursors a laminated paper for preventing adhesion of the plate precursors and scratching due to abrasion between the surface of the relatively soft protective layer and the aluminum support. As a result, the period needed for removing the laminated paper results in inefficiency in the exposure step. For improving efficiency in the exposure step, it is desirable to eliminate the step of removing the laminated paper by using a laminate containing no laminated paper between the precursors, and thus, there is a need for a method of improving the adhesion resistance of the planographic printing plate precursors and preventing scratching due to abrasion between the protective layer surface and the aluminum support.

For the reasons above, there is a need for a photo-polymerizable planographic printing plate precursor comprising a protective layer suppressing the polymerization inhibition in photosensitive layer, which does not require a step of removing a laminated paper and which improves the productivity in a plate-making operation, and a plate-making method for producing the same.

### SUMMARY OF THE INVENTION

The present invention provides a planographic printing plate precursor capable of being printed with infrared laser and comprising a protective layer that improves the productivity of plate-making operations, and a plate-making method thereof. More specifically, it provides a planographic printing plate precursor comprising a protective layer that suppresses the polymerization inhibition of the photosensitive layer, is superior in removability during development, and controls the abrasion between the protective layer surface of the planographic printing plate precursor and the support-sided surface of the neighboring planographic printing plate precursor even when the planographic printing plate precursors are layered, and thus prevents the abrasion scratches generated between the protective layer surface and the rear face of the aluminum support, on a photosensitive layer capable of being printed with an infrared laser, and a plate-making method thereof.

In a first aspect, the invention provides a planographic printing plate precursor comprising a photosensitive layer containing an infrared absorbent, a polymerization initiator, a polymerizable compound, and a binder polymer, and a protective layer formed in this order on a hydrophilic aluminum support surface, wherein the protective layer contains polyvinyalcohol having a saponification value of 91 mole % or more and a mica compound in an amount of 5 wt % to 50 wt % relative to the total weight of the protective layer.

In a second aspect, the invention provides the planographic printing plate precursor according to the first aspect, wherein the oxygen permeability of the protective layer at 25°C and -1 atm is 0.5 ml/m²·day to 100 ml/m²·day.

In a third aspect, the invention provides the planographic printing plate precursor according to the first aspect, wherein the binder polymer is a binder polymer having a repeating unit represented by the following Formula (i). 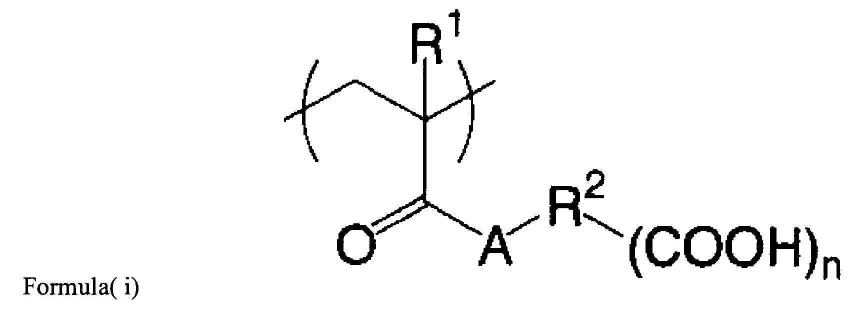 wherein R¹ represents a hydrogen atom or a methyl group, R² represents a connecting group which contains two or more atoms selected from the group consisting of a carbon atom, a hydrogen atom, an oxygen atom, a nitrogen atom, and a sulfur atom and which has 2 to 82 atoms in total, A represents an oxygen atom or -NR³-; R³ represents a hydrogen atom or a monovalent hydrocarbon group having 1 to 10 carbon atoms; and n represents an integer of 1 to 5.

In a fourth aspect, the invention provides the planographic printing plate precursor according to the first aspect, wherein the polyvinylalcohol is a polyvinylalcohol having an average degree of polymerization of the vinylalcohol unit at 300 to 2400.

In a fifth aspect, the invention provides the planographic printing plate precursor according to the first aspect, wherein the polyvinylalcohol having a saponification value of 91 mol % or more is an acid-modified polyvinylalcohol having an average degree of polymerization of the vinylalcohol unit at 100 to 800.

In a sixth aspect, the invention provides the planographic printing plate precursor according to the first aspect, wherein the polyvinylalcohol is used in combination with a binder component selected from the group consisting of polyvinylpyrrolidone, acidic celluloses, gelatin, Arabic gum, polyacrylic acid, and the copolymers thereof.

In a seventh aspect, the invention provides the planographic printing plate precursor according to the first aspect, wherein the mica compound is a mica selected from the group consisting of the natural and synthetic micas represented by the Formula: A(B,C)₂-5D₄O₁₀(OH,F,O)₂ wherein A represents K, Na, or Ca; each of B and C represents Fe(II), Fe(III), Mn, Al, Mg, or V; and D represents Si or Al.

In an eighth aspect, the invention provides the planographic printing plate precursor according to the seventh aspect, wherein the mica compound is a synthetic mica selected from the group consisting of non-swelling micas such as fluorine phlogopite KMg₃(AlSi₃O₁₀)F₂ and K tetrasilicic mica KMg_{2.5}(Si₄O₁₀)F₂; and swelling micas such as Na tetrasilicic mica NaMg_{2.5}(Si₄O₁₀)F₂, Na or Li teniolite (Na,Li)Mg₂Li(Si₄O₁₀)F₂, and montmorillonite-based Na or Li hectorite (Na,Li)_{1/8}Mg_{2/5}Li_{1/8}(Si₄O₁₀)F₂.

In a ninth aspect, the invention provides the planographic printing plate precursor according to the eighth aspect, wherein the mica compound is a fluorine-containing swelling mica.

In a tenth aspect, the invention provides the planographic printing plate precursor according to the first aspect, wherein the infrared absorbent is a dye or pigment having an absorption maximum at a wavelength of 750 to 1,400 nm.

In an eleventh aspect, the invention provides the planographic printing plate precursor according to the first aspect, wherein the coating amount of the protective layer is 0.1 g/m² to 2.0 g/m².

In a twelfth aspect, the invention provides a method of making the planographic printing plate precursor according to any one of the first to eleventh aspects, comprising: placing a laminate of planographic printing plate precursors formed by laminating multiple layers of a protective layer on an aluminum plate, the rear surface of which is brought into contact with the surface of the protective layer in a plate setter, conveying each of the planographic printing plate precursors automatically, exposing the precursor with a light having a wavelength of 750 nm to 1,400 nm, and developing the precursor practically without conducting heat treatment under the condition of a conveyance speed of 1.25 m/min or more.

### DETAILED DESCRIPTION OF THE INVENTION

### (Planographic printing plate precursor)

The planographic printing plate precursor according to the present invention comprises a photosensitive layer containing an infrared absorbent, a polymerization initiator, a polymerizable compound, and a binder polymer, and a protective layer formed in this order on a hydrophilic aluminum support surface, wherein the protective layer contains polyvinylalcohol having a saponification value of 91 mole % or more and a mica compound in an amount of 5 wt % to 50 wt % relative to the total weight of the protective layer.

Hereinafter, components of the planographic printing plate precursor according to the invention will be described in detail.

The phrase "formed in this order" means that a photosensitive layer and a protective layer are layered successively on a substrate, and may optionally contain any other layers such as intermediate layer and back coat layer, if necessary.

### <Protective layer>

The protective layer in the invention characteristically contains a polyvinylalcohol having a saponification value of 91 mole % or more (hereinafter, referred to as a "specific polyvinylalcohol") and a mica compound.

The polyvinylalcohol having a saponification value of 91 mol % or more is preferably an acid-modified polyvinylalcohol having an average degree of polymerization of the vinylalcohol unit at 100 to 800.

In the specification, the average degree of polymerization of the vinylalcohol unit may be referred to simply as "average degree of polymerization".

The planographic printing plate precursor according to the invention comprises a polymerizable negative type photosensitive layer (described hereinafter) as its photosensitive layer, and comprises a protective layer additionally on the photosensitive layer for preventing intrusion of oxygen, water, and low-molecular weight compounds such as basic substances present in air that inhibit the image-forming reaction into the photosensitive layer, due to normally performing exposure in air.

Addition of a specific polyvinylalcohol and a mica compound to the protective layer formed for that purpose is effective in producing a planographic printing plate precursor superior in film strength and also in providing the protective layer with a matted surface. As a result, the protective layer can block the incorporation of materials present in air such as oxygen and suppresses deterioration, for example, by deformation generated by scratches. In addition, because the protective layer is matt-surfaced, it is possible to suppress the adhesion between the protective layer surface of the planographic printing plate precursor and the rear face of the support of the neighboring planographic printing plate precursor when the planographic printing plate precursors according to the invention are laminated.

Hereinafter, the specific polyvinylalcohol and the mica compound will be described.

### (Specific polyvinylalcohol)

In the invention, basic properties desirable for the protective layer that is formed on a polymerizable negative type photosensitive layer are low permeability of low-molecular weight compounds such as oxygen, without substantially inhibiting the permeation of light for use in exposure, high adhesiveness to the photosensitive layer, and easier removal in the developing step after exposure.

Thus in the invention, to obtain the basic properties desirable for the protective layer, a polyvinylalcohol having a saponification value of 91 mole % or more (specific polyvinylalcohol) is used as the binder component for the protective layer. The specific polyvinylalcohol has an excellent film-forming property.

The polyvinylalcohol having a saponification value of 91 mole % or more for use in the invention has a desirable oxygen-blocking property and a desirable water-solubility if the saponification value falls in this range, and thus may be partially substituted or modified with an ester, ether, or acetal group and may also have another copolymerization component partially as far as it has unsubstituted vinylalcohol units.

Generally, a higher saponification value of the PVA used (higher content of the unsubstituted vinylalcohol units in the protective layer) leads to a higher oxygen-blocking property and thus is advantageous from the viewpoint of sensitivity. Accordingly, it is possible to improve the film strength further and thus raise the scrach resistance and oxygen-blocking property of the protective layer, for example, by using a polyvinylalcohol having a saponification value of 91 mole % or more in combination with a mica compound described hereinafter.

Such a specific polyvinylalcohol has preferably an average degree of polymerization of the vinylalcohol unit at 300 to 2400. Specific examples thereof include PVA-102, PVA-103, PVA-104, PVA-105, PVA-110, PVA-117, PVA-120, PVA-124, PVA-117H, PVA-135H, PVA-HC, PVA-617, PVA-624, PVA-706, PVA-613, PVA-CS, and PVA-CST manufactured by Kuraray Co. Ltd.; Gohsenol NL-05, NM-11, NM-14, AL-06, P-610, C-500, A-300, and AH-17 manufactured by Nippon Synthetic Chemical Industry Co., Ltd.; JF-04, JF-05, JF-10, JF-17, JF-17L, JM-05, JM-10, JM-17, JM-17L, JT-05, JT-13, and JT-15 manufactured by Japan VAM & POVAL Co., Ltd.; and the like.

The specific polyvinylalcohol in the invention is not particularly limited if it has a saponification value of 91 mol % or more, and favorable examples thereof include carboxy-modified polyvinylalcohols modified, for example, with itaconic acid or maleic acid, sulfonic acid-modified polyvinylalcohols, and the like. The specific polyvinylalcohol modified with an acid is effective in suppressing deterioration in the removability of photosensitive layer during development. Typical examples of the acid-modified polyvinylalcohols having a high saponification value include KL-118 (saponification value: 97 mol %, average degree of polymerization: 1,800), KM-618 (saponification value: 94 mol %, average degree of polymerization: 1,800), and KM-118 (saponification value: 97 mol %, average degree of polymerization: 1,800) manufactured by Kuraray Co. Ltd.; Ghosenal T-330H (saponification value: 99 mol %, average degree of polymerization: 1,700), Ghosenal T-330 (saponification value: 96.5 mol %, average degree of polymerization: 1,700), Ghosenal T-350 (saponification value: 94 mol %, average degree of polymerization: 1,700), Ghosenal T-230 (saponification value: 96.5 mol %, average degree of polymerization: 1,500), GhosenalT-215 (saponification value: 96.5 mol %, average degree of polymerization: 1,300), and Ghosenal T-HS-1 (saponification value: 99 mol %, average degree of polymerization: 1,300) manufactured by Nippon Synthetic Chemical Industry Co., Ltd.; AF-17 (saponification value: 96.5 mol %, average degree of polymerization: 1,700) and AT-17 (saponification value: 93.5 mol %, average degree of polymerization: 1,700) manufactured by Japan VAM & POVAL Co., Ltd.; and the like.

The specific polyvinylalcohol having a low degree of polymerization and a high saponification value is not particularly limited if it has a saponification value of 91 mol % or more and an average degree of polymerization of the vinylalcohol unit at 100 to 800, and favorable examples thereof include carboxy-modified polyvinylalcohols modified, for example, with itaconic acid or maleic acid and sulfonic acid-modified polyvinylalcohols.

Typical examples thereof include SK-5102 (saponification value: 98 mol %, average degree of polymerization: 200) and KM-106 (saponification value: 98.5 mol %, average degree of polymerization: 600) manufactured by Kuraray Co. Ltd., and Ghosenal CKS-50 (saponification value 99 mol %, average degree of polymerization 300) manufactured by Nippon Synthetic Chemical Industry Co., Ltd.

The specific polyvinylalcohol is preferably contained in the protective layer in an amount in the range of 45 to 95 wt %, more preferably 50 to 90 wt %, relative to the total solid content in the protective layer. A content of less than 45 wt % leads to deterioration in film-forming property and thus in sensitivity, while a content of more than 95 wt % makes it less effective to control the adhesion between layered planographic printing plate precursors.

At least one of the specific polyvinylalcohols is used, and multiple polyvinylalcohols may be used in combination. When multiple specific polyvinylalcohols are used together, the total amount is preferably in the weight range above.

### (Mica compound)

Examples of the mica compounds for use in the invention include the natural and synthetic micas represented by Formula: A(B,C)₂-5D₄O₁₀(OH,F,O)₂ wherein A represents K, Na, or Ca; each of B and C represents Fe(II), Fe(III), Mn, Al, Mg, or V; and D represents Si or Al.

Among the micas mentioned above, the natural micas include white mica, soda mica, gold mica (phlogopite), black mica, and scaly mica (lepidolite). Examples of the synthetic micas include swelling micas such as fluorophlogopite KMg₃(AlSi₃O₁₀)F₂ and potassium tetrasilicic mica KMg_{2.5}(Si₄O₁₀)F₂; and swelling micas such as sodium tetrasilicic mica NaMg_{2.5}(Si₄O₁₀)F₂, Na or Li type teniolite (Na,Li)Mg₂Li(Si₄O₁₀)F₂, and montmorillonite Na or Li hectorite (Na,Li)_{1/8}Mg_{2/5}Li_{1/8}(Si₄O₁₀)F₂; and the like. Synthetic smectites are also useful.

In the invention, fluorine-containing swelling micas are particularly useful among the mica compounds mentioned above. The swelling synthetic micas have a laminated structure of unit crystal lattice layers having a thickness of approximately 10 to 15 A, and show metal atoms substitution in lattices of particularly high degree compare with other clay minerals. As a result, the lattice layers become deficient in the amount of positive charges, and cations such as Na⁺, Ca²⁺, or Mg²⁺ are absorbed between the layers to compensate the deficiency. The cations present between the layers are called exchangeable cations and can be exchanged with various cations. When the cations between the layers are Li⁺ or Na⁺ in particular, the small ionic radii provide weak linkage of crystal-layer lattices, and thus the mica compound swells significantly with water. If a shear is applied to the mica compound in that state, the mica compound is easily cleaved and form stable sol in water. Swelling synthetic micas strongly tend to show that property and they are preferred for the purpose of the present invention. In particular, swelling synthetic mica can be preferably used.

As for the shape of the mica compound for use in the invention, a smaller thickness is more preferable from the viewpoint of diffusion control, and a larger face size is more preferable so long as smoothness of coated surface or the transparency of activated light is not degraded. Therefore, the aspect ratio is 20 or more, preferably 100 or more, and particularly preferably 200 or more. The aspect ratio is a ratio of the thickness to the length of particle, and is determined, for example, from the projected drawing of the particle in micrograph. A larger aspect ratio leads to a greater advantageous effect.

Particles of the mica compound for use in the invention preferably have an average length of 0.3 to 20 µm, preferably 0.5 to 10 µm, and particularly preferably 1 to 5 µm. The average thickness of the particle is preferably 0.1 µm or less, more preferably 0.05 µm or less, and particularly preferably 0.01 µm or less. Specifically, for example, typical swelling synthetic mica has a thickness of 1 to 50 nm and a face size (length) of approximately 1 to 20 µm.

The amount of the mica compound contained in the protective layer is in the range of 5 to 50 wt %, preferably 10 to 40 wt %, relative to the total solid content in the protective layer. There is no effect suppressing the adhesion between laminated planographic printing plate precursors or controlling generation of scratch at a content of less than 5 wt %, while at a content of more than 50 wt %, the protective layer has an excessively smaller oxygen permeability, resulting in increase in the fogging for example by UV-cut light, and has lowered film transparency and sensitivity. When multiple mica compounds are used, the total amount of these mica compounds is in the weight range above.

The components for the protective layer (selection of PVA and mica compound, use of additives), the coating amount thereof, and others are determined properly according to the desirable oxygen-blocking property, removability during development, fogging property, adhesiveness, and scrach resistance.

The oxygen permeability of the protective layer in the invention at 25°C and -1 atm is preferably 0.5 ml/m²·day to 100 ml/m²·day, and it is preferable to use a method of controlling the coating amount for obtaining the desirable oxygen permeability above.

On the other hand, in the protective layer, the adhesiveness to the image region of the photosensitive layer and the uniformity of film are also extremely important in handling the plate. When a hydrophilic layer of water-soluble polymer is formed on an oleophilic photosensitive layer, the laminated layers are easily separated from each other because of low adhesive strength, causing defects such as insufficient film hardening due to the polymerization inhibition by oxygen in the separated region. To solve the problem, various methods of improving the adhesiveness between these two layers have been proposed. For example, US Patent Application Nos. 292,501 and 44,563 described that it was possible to obtain a sufficiently high adhesiveness by blending an acrylic emulsion or water-insoluble vinylpyrrolidone-vinyl acetate copolymer to a hydrophilic polymer mainly of polyvinylalcohol in an amount of 20 to 60 wt % and applying the mixture on a photosensitive layer.

Any one of these known methods may be applied for forming the protective layer in the invention, as far as the advantageous effects of containing a specific polyvinylalcohol and a mica compound are not degraded.

In particular in the protective layer, the specific polyvinylalcohol above and polyvinylpyrrolidone may be used in combination as binder components, from the viewpoint of the adhesiveness and sensitivity of the photosensitive layer and prevention of undesirable fogging. In addition, the addition ratio of specific polyvinylalcohol /polyvinylpyrrolidone is preferably 3/1 or less (by weight).

In addition to polyvinylpyrrolidone, acidic cellulose, gelatin, Arabic gum, polyacrylic acid, or the copolymer thereof, which is relatively superior in crystallinity, may be used together with the specific polyvinylalcohol.

A colorant (water-soluble dye) that transmits the light used for exposure of the photosensitive layer (infrared light in the invention) efficiently and absorbs efficiently the light having a wavelength not associated with exposure may be added to the protective layer. In this way, it is possible to raise safelight endurance without reducing sensitivity.

### (Formation of protective layer)

The protective layer in the invention is formed by applying on a photosensitive layer a coating solution for protective layer obtained by preparing a dispersion of a mica compound and mixing a binder component containing the specific polyvinylalcohol above (or, aqueous solution of a binder component containing the specific polyvinylalcohol) with the dispersion.

First, an example of the general method of dispersing the mica compound for use in the protective layer will be described. First, 5 to 10 parts by weight of a swelling mica compound, one of the preferable mica compounds described above, is added to 100 parts by weight of water, allowing the mica to become compatible and swell with water, and then, the mixture is dispersed in a dispersing machine. Examples of the dispersing machines used include various mills that disperse while applying a mechanical force directly, high-speed-agitating dispersing machines having a great shearing force, dispersing machines applying a high-strength ultrasonic energy, and the like. Typical examples thereof include ball mill, sand grinder mill, visco mill, colloid mill, homogenizer, dissolver, polytron, homomixer, homoblender, Keddy mill, jet agitator, capillary emulsifier, liquid siren, electromagnetic-distortion ultrasonic wave generator, emulsifier having a Pallmann whistle, and the like. The dispersion of the mica compound at a concentration of 2 to 15 wt % prepared by the method above is highly viscous or in the gel state, and the storage stability thereof is extremely favorable.

In preparing a coating solution for protective layer by using the dispersion, the dispersion is preferably diluted with water and stirred sufficiently and mixed with a binder component containing the specific polyvinylalcohol (or, aqueous solution of a binder component containing the specific polyvinylalcohol).

Known additives such as surfactants for improving coating property and water-soluble plasticizers for improving the physical properties of film may be added to the coating solution for protective layer. Examples of the water-soluble plasticizers include propionamide, cyclohexanediol, glycerol, sorbitol and the like. In addition, a water-soluble (meth)acrylic polymer may be added. Further, known additives for improvement of the adhesiveness to the photosensitive layer and the storage stability of coating solution may be added to the coating solution.

The method of forming the protective layer in the invention is not particularly limited, and the method described in U.S. Patent No. 3,458,311 or JP-A No. 55-49729 may be used.

The coating amount of the protective layer in the invention is 0.1 g/m² to 2.0 g/m², and preferably 0.3 g/m² to 1.0 g/m². A coating amount of less than 0.1 g/m² may result in inferior film strength of the protective layer and deterioration in scrach resistance. Alternatively, a coating amount of more than 2.0 g/m² may lead to scattering of the incident light entering into the protective layer by exposure, consequently to deterioration of image quality, and excessively lowered oxygen permeability, which in turn leads to deterioration in safelight endurance.

### <Photosensitive layer>

The photosensitive layer of the planographic printing plate precursor according to the invention is a polymerizable negative photosensitive layer containing an infrared absorbent, a polymerization initiator, a polymerizable compound, and a binder polymer as essential components, and, additionally as needed, a colorant or any other components.

The polymerizable negative photosensitive layer in the invention is sensitive to infrared light and also to an infrared laser, which is useful for CTP printing. The infrared absorbent contained therein is activated into the electron excited state at high sensitivity by infrared laser irradiation (exposure), and the electron transfer, energy transfer, and heat generation (photothermal-converting function) associated with the electron excited state act to the polymerization initiator co-present in the photosensitive layer, inducing chemical change of the polymerization initiator to generate radicals.

Possible mechanisms for generation of radical include: 1. the heat generated by the photothermal-converting function of infrared absorbent decomposes the polymerization initiator described below (e.g., sulfonium salt) thermally, to generate radicals; 2. an excited electron generated in infrared absorbent is transferred to the polymerization initiator (e.g., active halogen compound), to generate radicals; and 3. the electron transfer from polymerization initiator (e.g., borate compound) to the excited infrared absorbent generates radicals; and the like. The generated radicals initiate the polymerization reaction of the polymerizable compound, forming an image region by curing the exposed area.

The planographic printing plate precursor according to the invention, which comprises a photosensitive layer containing an infrared absorbent, is particularly favorable for use in direct printing with infrared laser beam having a wavelength of 750 to 1,400 nm, and shows an image-forming property better than that of the conventional planographic printing plate precursors.

Hereinafter, components used in the photosensitive layer in the invention will be described.

### (Infrared absorbent)

The photosensitive layer in the invention contains an infrared absorbent for energy-transfer (electron transfer) or photothermal-conversion.

The infrared absorbent is activated into the electron excited state at highly sensitive by irradiation with infrared laser (exposure), and is effective in inducing the electron transfer, energy transfer, and heat generation (photothermal-converting function) associated with the electron excited state to act to the polymerization initiator described hereinafter, causing chemical change of the polymerization initiator at high sensitivity to generate radicals.

The infrared absorbent for use in the invention is preferably a dye or pigment having the absorption maximum at a wavelength of 750 nm to 1,400 nm.

Such a dye can be a commercially available dye, or a known dye disclosed in "Dye Handbook" edited by The Society of Synthetic Organic Chemistry, Japan and published in 1970. Specific examples thereof include an azo dye, a metal complex azo dye, a pyrazolone azo dye, a naphthoquinone dye, an anthraquinone dye, a phthalocyanine dye, a carbonium dye, a quinonimine dye, a methine dye, a cyanine dye, a squalelium dye, a pyrylium salt, and a metal thiolate complex.

The dye is preferably a cyanine dye disclosed in JP-A No. 58-125246, 59-84356, or 60-78787, a methine dye disclosed in JP-A No. 58-173696, 58-181690, or 58-194595, a naphthoquinone dye disclosed in No. 58-112793, 58-224793, 59-48187, 59-73996, 60-52940, or 60-63744, a squalelium dye disclosed in JP-A No. 58-112792, or a cyanine dye disclosed in U. K. Patent No. 434,875.

A near infrared ray absorption sensitizer disclosed in U.S. Patent No. 5,156,938, a substituted arylbenzo(thio)pyrylium salt disclosed in U.S. Patent No. 3,881,924, a trimethine thiapyrylium salt disclosed in JP-A No. 57-142645 (US. Patent No. 4,327,169), a pyrylium compound disclosed in JP-A No. 58-181051, 58-220143, 59-41363, 59-84248, 59-84249, 59-146063, or 59-146061, a cyanine dye disclosed in JP-A No. 59-216146, a pentamethine thiopyrylium salt disclosed in U.S. Patent No. 4,283,475, or a pyrylium salt disclosed in JP-B No. 5-13514, or 5-19702 is preferably used as the dye. The dye is also preferably a near infrared ray absorption dye represented by Formula (I) or (II) of U.S. Patent No. 4,756,993.

Moreover, the infrared ray absorption dye in the invention is also preferably a specific indolenine cyanine dye disclosed in JP-A No. 2002-278057, which will be illustrated below:

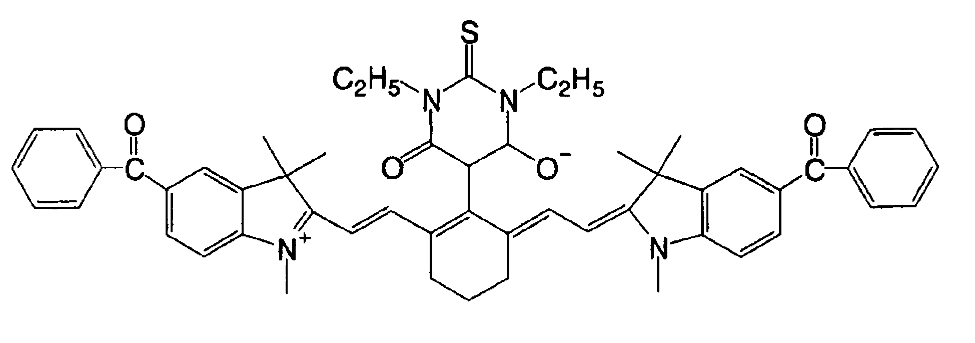

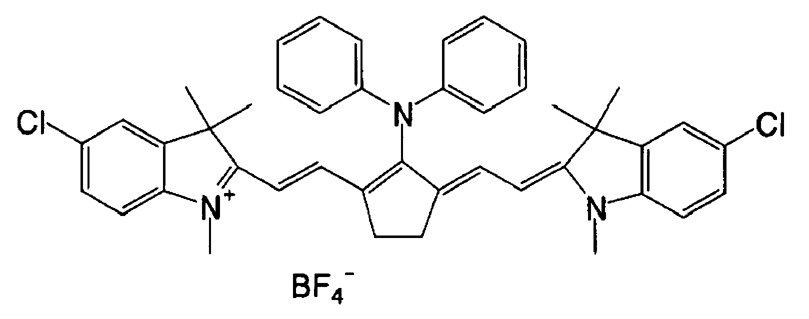

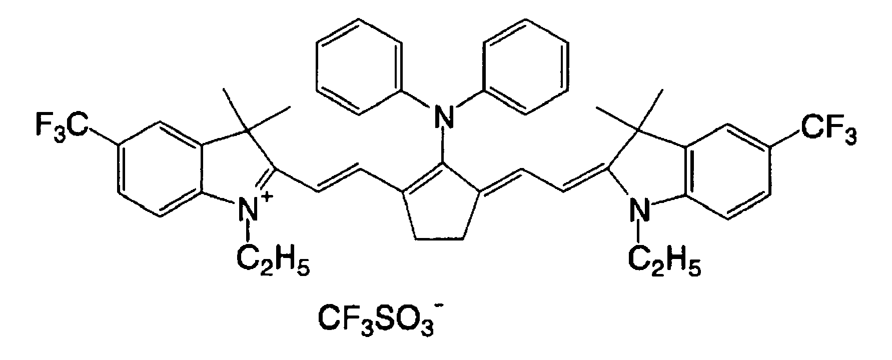

The infrared ray absorption dye in the invention is more preferably a cyanine dye, a squalelium dye, a pyrylium salt, a nickel thiolate complex, or an indolenine cyanine dye, still more preferably a cyanine dye or an indolenine cyanine dye, and particularly preferably a cyanine dye represented by the following Formula (a).

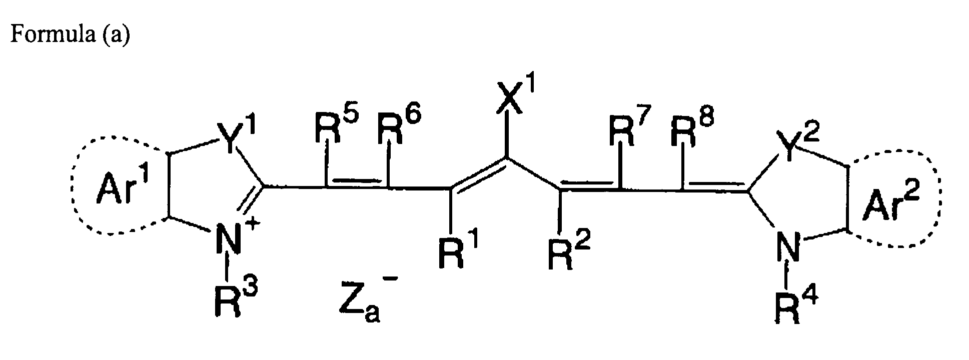

In formula (a), X¹ represents a hydrogen atom, a halogen atom, -NPh₂, X²-L¹, or a group shown below in Formula (b). X² represents an oxygen atom, a nitrogen atom, or a sulfur atom, and L¹ represents a hydrocarbon group having 1 to 12 carbon atoms, an aromatic ring having at least one hetero atom, or a hydrocarbon group containing at least one hetero atom and having 1 to 12 carbon atoms. The hetero atom is N, S, O, a halogen atom, or Se. In the Formula (b), definition of Xₐ⁻ is the same as that of Zₐ⁻ described hereinafter, and R^{a} represents a hydrogen atom or a substituent selected from alkyl groups, aryl groups, substituted or unsubstituted amino groups, and halogen atoms.

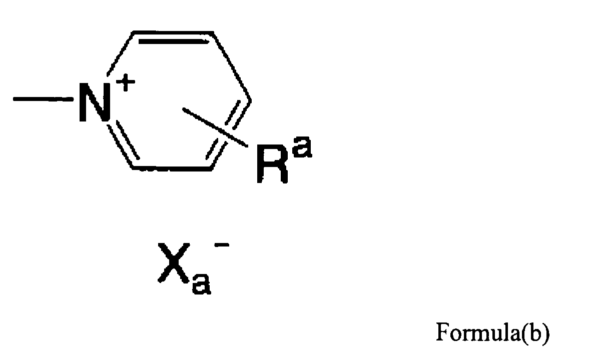

In formula (b), R¹ and R² each independently represent a hydrocarbon group having 1 to 12 carbon atoms. R¹ and R² is preferably a hydrocarbon group having two or more carbon atoms from the viewpoint of storage stability of a coating liquid for the photosensitive layer. R¹ and R² particularly preferably bind to each other to form a five- or six-membered ring.

In formula (a), Ar¹ and Ar² may be the same or different, and represent an aromatic hydrocarbon group which may have a substituent. Typical examples of the aromatic hydrocarbon group include a benzene ring and a naphthalene ring. Also, typical examples of the substituent include a hydrocarbon group having 12 or less carbon atoms, halogen atoms and alkoxy groups having 12 or less carbon atoms. Y¹ and Y² may be the same or different, and represent a sulfur atom or a dialkylmethylene group having 12 or less carbon atoms. R³ and R⁴ may be the same or different, and represent a hydrocarbon group which may have a substituent and which has 20 or less carbon atoms. Typical examples of the substituent include alkoxy groups having 12 or less carbon atoms, a carboxyl group and a sulfo group. R⁵, R⁶, R⁷ and R⁸ may be the same or different, and represent a hydrogen atom or a hydrocarbon group having 12 or less carbon atoms. In light of availability of raw materials, they are preferably hydrogen atoms. Zₐ represents a counter anion, provided that Zₐ⁻ is not necessary, if the cyanine pigment represented by Formula (a) has an anionic substituent in its structure, and therefore does not need for neutralization of charges due to a counter anion. Zₐ⁻ is preferably a halogen ion, a perchlorate ion, a tetrafluoro borate ion, a hexafluorophosphate ion or a sulfonate ion from the viewpoint of storage stability of the coating liquid for the photosensitive layer. Za⁻ is more preferably a perchlorate ion, a hexafluorophosphate ion or an arylsulfonate ion.

Typical examples of the cyanine dye represented by Formula (a) preferably used in the invention include those described in paragraph Nos. [0017] to [0019] in JP-A No. 2001-133969.

The cyanine dye is particularly preferably a specific indolenine cyanine dye described in JP-A No. 2002-278057.

Note that a counter ion which does not contain halogen ion is particularly preferable.

The pigment used in the invention may be a commercially available pigment or a pigment described in Color Index (C.I.) Handbook, "Latest Pigment Handbook" (edited by Japan Pigment Technique Association, and published in 1977), "Latest Pigment Applied Technique" (by CMC Publishing Co., Ltd. in 1986), and "Printing Ink Technique" (by CMC Publishing Co., Ltd. in 1984).

Examples of the pigment include black pigments, yellow pigments, orange pigments, brown pigments, red pigments, purple pigments, blue pigments, green pigments, fluorescent pigments, metal powder pigments, and polymer-bonded dyes. Specifically, insoluble azo pigments, azo lake pigments, condensed azo pigments, chelate azo pigments, phthalocyanine pigments, anthraquinone pigments, perylene and perynone pigments, thioindigo pigments, quinacridone pigments, dioxazine pigments, isoindolinone pigments, quinophthalone pigments, dyeing lake pigments, azine pigments, nitroso pigments, nitro pigments, natural pigments, fluorescent pigments, inorganic pigments, and carbon black can be used. The pigment is preferably carbon black.

These pigments may or may not be surface-treated. Examples of the surface treatment include a method of coating the surface of the pigment with a resin or wax; a method of adhering a surfactant onto the surface; and a method of bonding a reactive material (such as a silane coupling agent, an epoxy compound, or a polyisocyanate) to the surface. The surface treatment methods are described in "Nature and Application of Metal Soap" (Saiwai Shobo), "Printing Ink Technique" (by CMC Publishing Co., Ltd. in 1984), and "Latest Pigment Applied Technique" (by CMC Publishing Co., Ltd. in 1986).

The diameter of the pigment particle is preferably in a range of 0.01 to 10 µm, more preferably in a range of 0.05 to 1 µm, and still more preferably in a range of 0.1 to 1 µm. Pigment particles having a diameter within this preferable range are stably dispersed in the photosensitive layer and thus enable formation of a uniform photosensitive layer.

The pigment may be dispersed by a known dispersing technique used in the production of an ink or a toner. Examples of a dispersing machine used therein include an ultrasonic disperser, a sand mill, an attritor, a pearl mill, a super mill, a ball mill, an impeller, a disperser, a KD mill, a colloid mill, a dynatron, a three-roll mill, and a pressing kneader, of which the details are described in "Latest Pigment Applied Technique" (by CMC Publishing Co., Ltd. in 1986).

When used in the photosensitive layer, the infrared absorbent may be added to the layer together with other components, or to another layer separately.

From the viewpoints of uniformity of the infrared ray absorbent in the photosensitive layer and durability of the photosensitive layer, the content of the infrared ray absorbent in the photosensitive layer is generally 0.01 to 50 % by weight, preferably 0.1 to 10 % by weight, and more preferably 0.5 to 10 % by weight (in a case of the dye) or 0.1 to 10 % by weight (in a case of pigment), relative to the total solid content of the photosensitive layer.

### (Polymerization initiator)

The polymerization initiator used in the invention may be any compound that has a function of initiating and advancing the curing reaction of a polymerizable compound described hereinafter and can generate radicals due to application of energy. Such a compound can be a thermal decomposition-type radical generator that, when heated, decomposes to generate radicals, an electron transfer-type radical generator that receives an excited electron from the infrared ray absorbent to generate radicals, or an electron transfer-type radical generator that generates electrons, which move to the excited infrared ray absorbent so as to generate radicals. Specific examples thereof include onium salts, activated halogen compounds, oxime ester compounds, and borate compounds. Two or more of these initiators may be used together. In the invention, the polymerization initiator is preferably an onium salt, and more preferably a sulfonium salt.

The sulfonium salt polymerization initiator preferably used in the invention can be an onium salt represented by the following Formula (1).

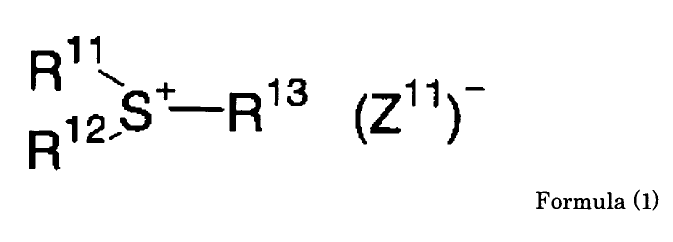

In formula (1), R¹¹, R¹² and R¹³ may be the same or different, and each represents a hydrocarbon group having 20 or less carbon atoms which may have at least one substituent. Examples of the substituent selected include halogen atoms, a nitro group, alkyl groups having 12 or less carbon atoms, alkoxy groups having 12 or less carbon atoms, and aryloxy groups having 12 or less carbon atoms. Z¹¹⁻ represents a counter ion selected from the group consisting of a halogen ion, a perchlorate ion, a tetrafluoroborate ion, a hexafluorophosphate ion, a carboxylate ion, and a sulfonate ion. Z¹¹⁻ is preferably a perchlorate ion, a hexafluorophosphate ion, a carboxylate ion, or an arylsulfonate ion.

Hereinafter, typical examples of the onium salt represented by Formula (1), [OS-1] to [OS-12] are shown below, but the invention is not limited thereto.

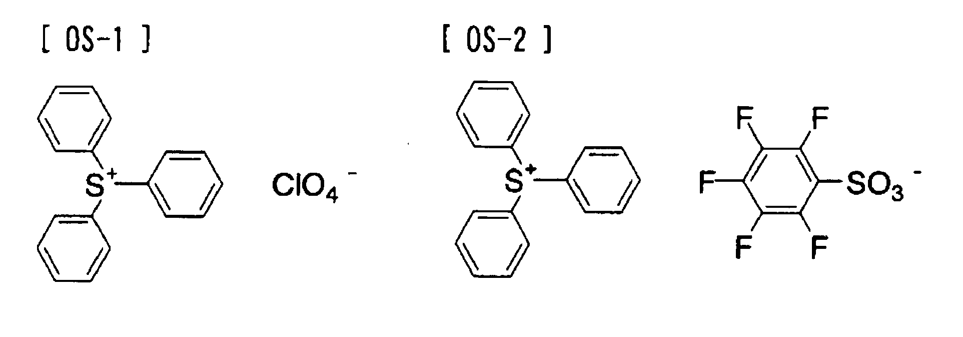

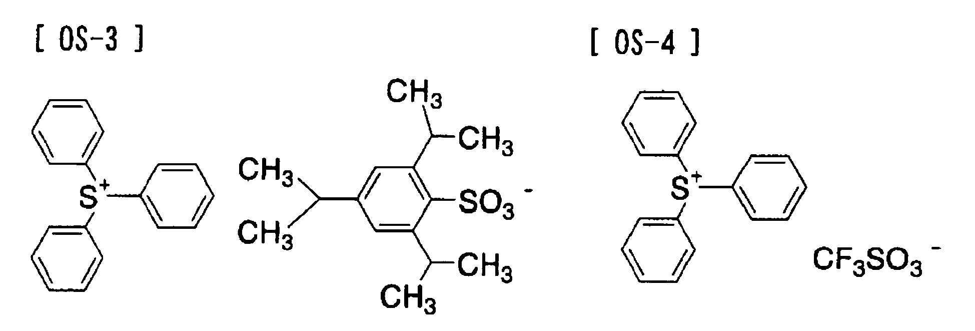

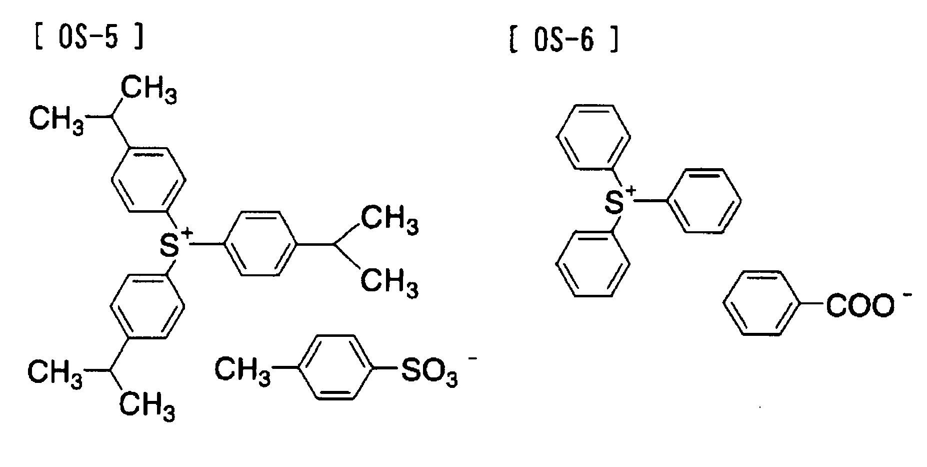

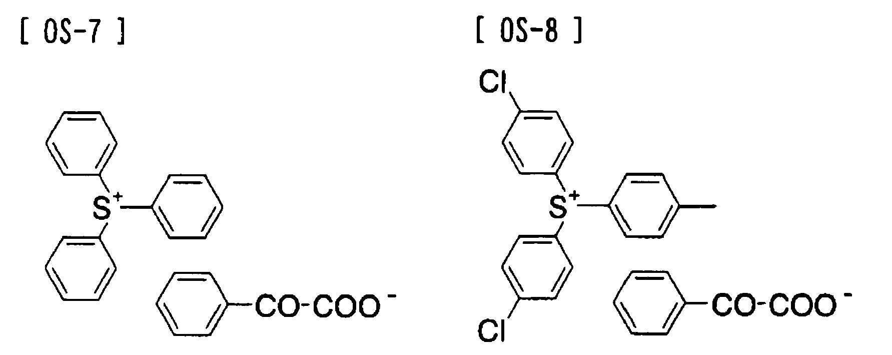

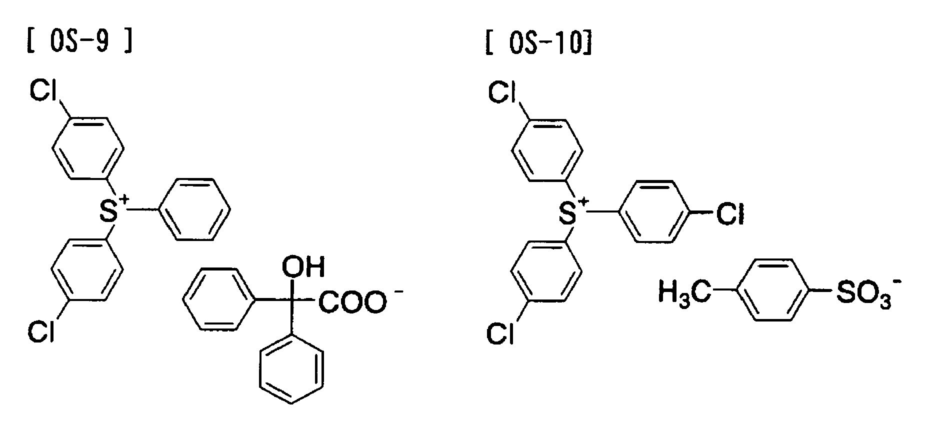

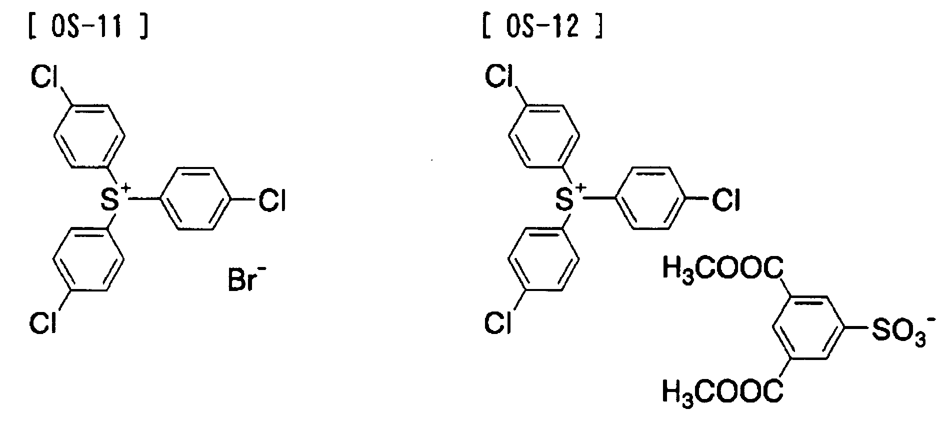

In addition, the specific aromatic sulfonium salts described in JP-A Nos. 2002-148790, 2002-350207, and 2002-6482 are also preferably used as the polymerization initiator.

In the invention, not only the sulfonium salt polymerization initiator, but also other polymerization initiators (other radical generators) may also be used. Examples of other radical generators include onium salts other than sulfonium salts, triazine compounds having a trihalomethyl group, peroxides, azo polymerization initiators, azide compounds, quinone diazide, activated halogen compounds, oxime ester compounds, and triaryl monoalkyl borate compounds. Among them, onium salts are preferably used, since they are highly sensitive. In addition, any of these polymerization initiators (radical generator) may be used together with the above-described sulfonium salt polymerization initiator, which is used as an essential component.

Examples of the onium salts which can be used preferably in the invention include iodonium salts and diazonium salts. In the invention, these onium salts function not as acid generating agents but as radical polymerization initiators.

The other onium salts represented by the following Formulae (2) and (3) can be also used.

Ar²¹―I⁺―Ar²² (Z²¹)⁻ Formula(2)

Ar³¹―N⁺≡N (Z³¹)⁻ Formula(3)

In formula (2), Ar²¹ and Ar²² each independently represent an aryl group having 20 or less carbon atoms which may have at least one substituent. When the aryl group has at least one substituent, typical examples of the substituent include halogen atoms, a nitro group, alkyl groups having 12 or less carbon atoms, alkoxy groups having 12 or less carbon atoms, and aryloxy groups having 12 or less carbon atoms. Z²¹⁻ is a counter ion having the same definition as that of Z¹¹⁻.

In formula (3), Ar³¹ represents an aryl group having 20 or less carbon atoms which may have at least one substituent. Typical examples of the substituent include halogen atoms, a nitro group, alkyl groups having 12 or less carbon atoms, alkoxy groups having 12 or less carbon atoms, aryloxy groups having 12 or less carbon atoms, alkylamino groups having 12 or less carbon atoms, dialkylamino groups having 12 or less carbon atoms, arylamino groups having 12 or less carbon atoms, and diarylamino groups having 12 or less carbon atoms. Z³¹⁻ is a counter ion having the same definition as that of Z¹¹⁻.

As the typical examples of the onium salt represented by Formula (2), [OI-1] to [OI-10] and as the onium salt represented by Formula (3), [ON-1] to [ON-5] are shown below, but the invention is not limited thereto.

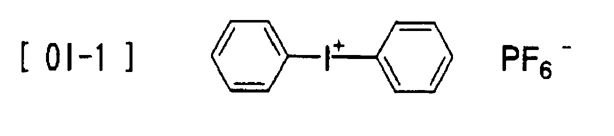

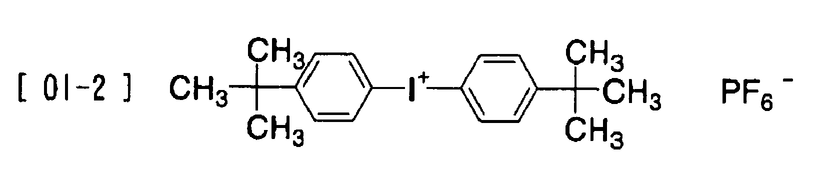

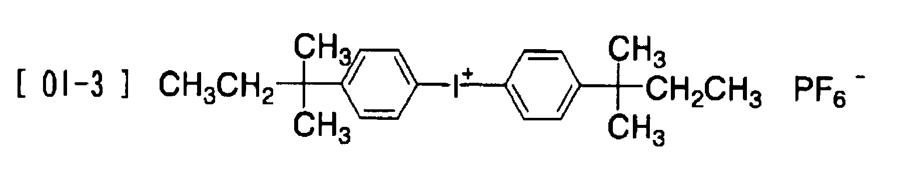

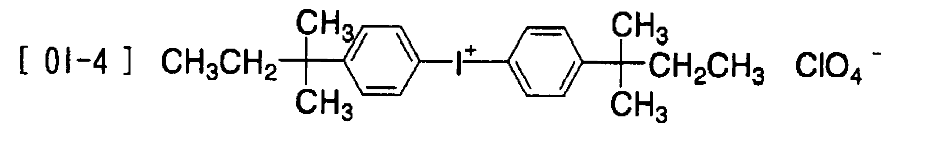

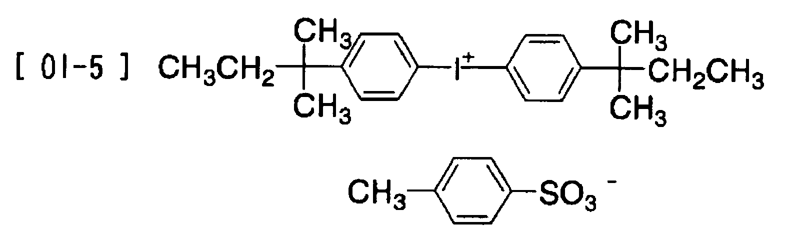

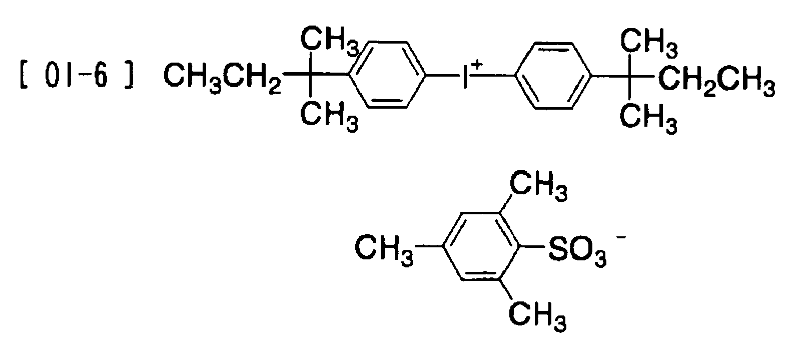

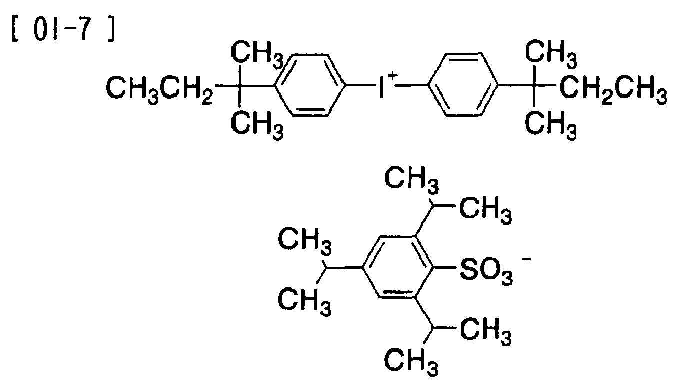

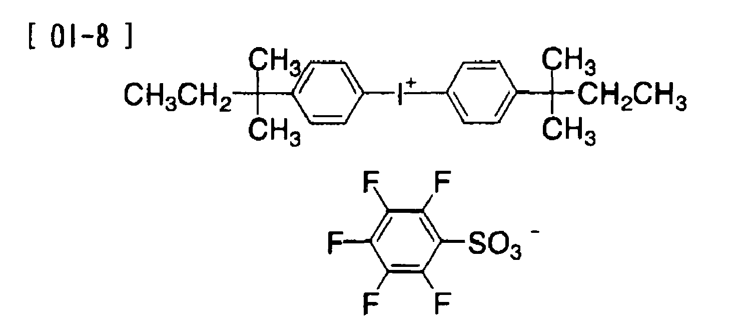

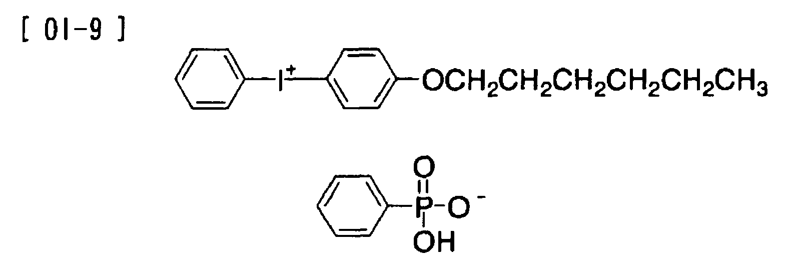

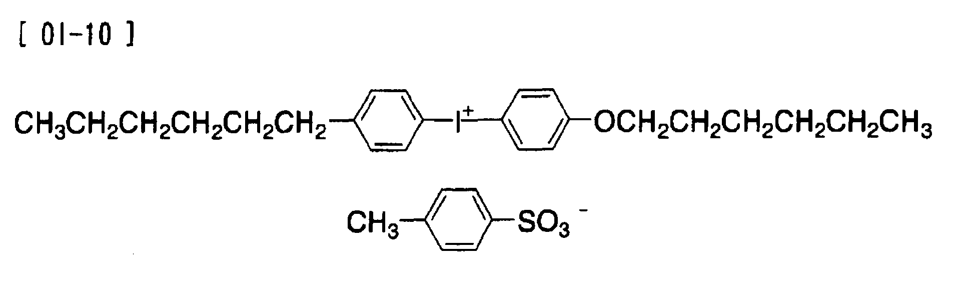

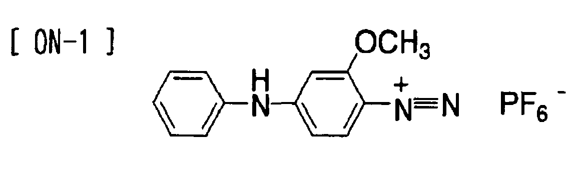

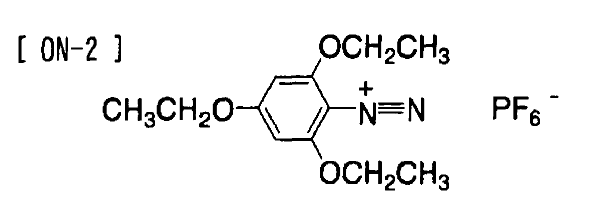

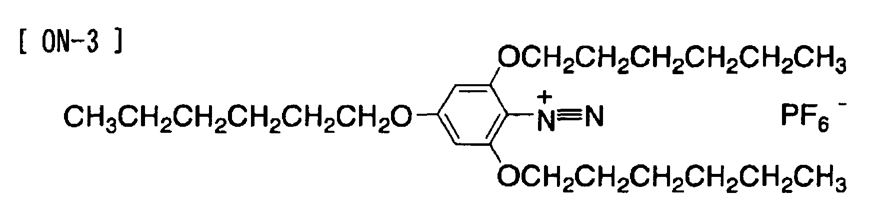

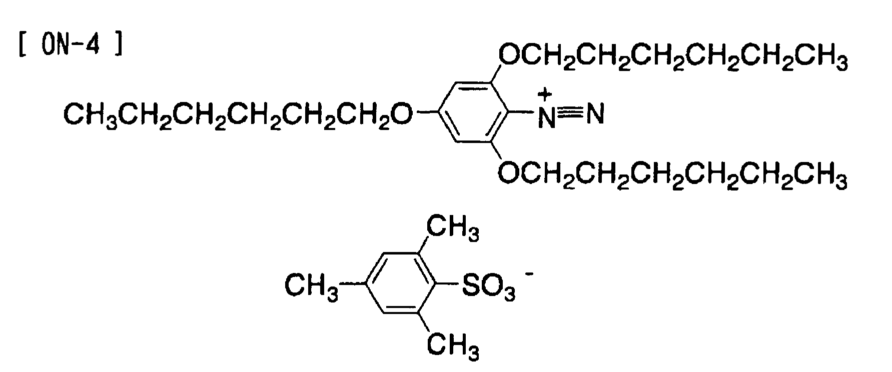

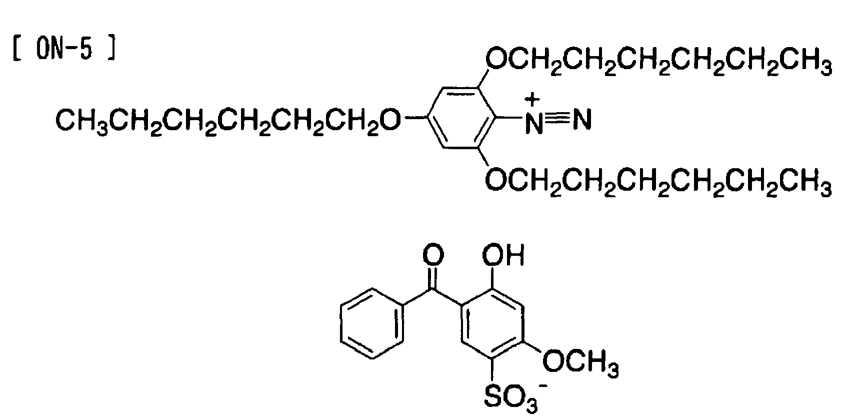

Specific examples of the onium salts preferably used as the polymerization initiator (radical generator) in the invention include those described in JP-A No. 2001-133696.

Further, the polymerization initiator (radical generator) used in the invention preferably has a maximum absorption wavelength of 400 nm or less, and more preferably has a maximum absorption wavelength of 360 nm or less. When the polymerization initiator (radical generator) has its absorption wavelength in the UV range, the planographic printing plate precursor can be handled under a white lamp.

The total content of the polymerization initiator(s) in the invention is 0.1 to 50 % by weight, preferably 0.5 to 30 % by weight, and more preferably 1 to 20 % by weight relative to the total solid matters constituting the photosensitive layer from the viewpoints of sensitivity and prevention of stains on the non-image portion during printing.

In the invention, a polymerization initiator may be used or two or more polymerization initiators can be used together. When two or more polymerization initiators are used together, two or more sulfonium salt polymerization initiators may be used, or alternatively, a combination of a sulfonium salt polymerization initiator and any other polymerization initiators may be used.

When a sulfonium salt polymerization initiator and another polymerization initiator are used in combination, the weight ratio of these initiators is preferably 100/1 to 100/50 and more preferably 100/5 to 100/25.

In addition, the polymerization initiator and the other component may be contained in the same layer or in different layers.

When a highly sensitive sulfonium salt serving as a typical polymerization initiator is used in the photosensitive layer of the invention, the radical polymerization reaction effectively proceeds and the intensity of image portion formed is very high. Accordingly, when a photosensitive layer is combined with a protective layer described hereinafter, which has a high oxygen-blocking function, a planographic printing plate having a very high intensity of the image portion can be produced, and consequently the printing durability of the plate is further improved. Further, the sulfonium salt polymerization initiator is superior in storability over time, and, when a planographic printing plate precursor containing the sulfonium salt polymerization initiator is stored, an undesirable polymerization reaction is effectively suppressed.

### (Polymerizable compound)

The polymerizable compound used in the invention is an addition polymerizable compound having at least one ethylenically unsaturated double bond, and is selected from compounds having at least one, and preferably 2 or more, ethylenically unsaturated double bonds. Such compounds are widely known in this industrial field, and any of these compounds may be used in the invention, which are not particularly limited. These have a chemical form such as, for example, a monomer, a prepolymer, i.e., a dimer, a trimer and an oligomer, or a mixture or a copolymer of two or more of these compounds. Examples of the monomer and the copolymer thereof include unsaturated carboxylic acids (e.g., acrylic acid, methacrylic acid, itaconic acid, crotonic acid, isocrotonic acid, and maleic acid), and esters and amides thereof. The polymerizable compound is preferably an ester of an unsaturated carboxylic acid and an aliphatic polyhydric alcohol compound, or an amide of an unsaturated carboxylic acid and an aliphatic polyvalent amine compound. In addition, an addition reaction product of an unsaturated carboxylate having a nucleophilic substituent such as a hydroxyl group, an amino group or a mercapto group, or an amide thereof, and a monofunctional or polyfunctional isocyanate, or an epoxy compound; and a dehydration condensation reaction product of such an unsaturated carboxylate or an amide, and a monofunctional or polyfunctional carboxylic acid may be preferably used. Furthermore, an addition reaction product of an unsaturated carboxylate having an electrophilic substituent such as an isocyanate group or an epoxy group, or an amide thereof, and a monofunctional or polyfunctional alcohol, amine or thiol; a substitution reaction product of an unsaturated carboxylate having a leaving substituent such as halogen atoms or a tosyloxy group, or an amide thereof, and a monofunctional or polyfunctional alcohol, amine or thiol are also preferably used. Alternatively, monomers and prepolymers, and mixtures and copolymers thereof which are the same as the above except that the aforementioned unsaturated carboxylic acid is replaced with an unsaturated phosphonic acid, styrene, or vinylether may be also used.

Specific examples of the ester monomer of an aliphatic polyhydric alcohol compound and an unsaturated carboxylic acid include acrylates, methacrylates, itaconates, crotonates, isocrotonates, and maleates. Examples of acrylates include ethylene glycol diacrylate, triethylene glycol diacrylate, 1,3-butanediol diacrylate, tetramethylene glycol diacrylate, propylene glycol diacrylate, neopentyl glycol diacrylate, trimethylolpropane triacrylate, trimethylolpropane tri(acryloyloxypropyl) ether, trimethylolethane triacrylate, hexanediol diacrylate, 1,4-cyclohexanediol diacrylate, tetraethylene glycol diacrylate, pentaerythritol diacrylate, pentaerythritol triacrylate, pentaerythritol tetraacrylate, dipentaerythritol diacrylate, dipentaerythritol hexaacrylate, sorbitol triacrylate, sorbitol tetraacrylate, sorbitol pentaacrylate, sorbitol hexaacrylate, tri(acryloyloxyethyl)isocyanurate, and polyester acrylate oligomer.

Examples of the methacrylates include tetramethylene glycol dimethacrylate, triethylene glycol dimethacrylate, neopentyl glycol dimethacrylate, trimethylolpropane trimethacrylate, trimethylolethane trimethacrylate, ethylene glycol dimethacrylate, 1,3-butanediol dimethacrylate, hexanediol dimethacrylate, pentaerythritol dimethacrylate, pentaerythritol trimethacrylate, pentaerythritol tetramethacrylate, dipentaerythritol dimethacrylate, dipentaerythritol hexamethacrylate, sorbitol trimethacrylate, sorbitol tetramethacrylate, bis[p-(3-methacryloxy-2-hydroxypropoxy)phenyl]dimethylmethane, and bis[p-(methacryloxyethoxy)phenyl]dimethylmethane.

Examples of the itaconates include ethylene glycol diitaconate, propylene glycol diitaconate, 1,3-butanediol diitaconate, 1,4-butanediol diitaconate, tetramethylene glycol diitaconate, pentaerythritol diitaconate, and sorbitol tetraitaconate.

Examples of the crotonates include ethylene glycol dicrotonate, tetramethylene glycol dicrotonate, pentaerythritol dicrotonate, and sorbitol tetradicrotonate.

Examples of the isocrotonates include ethylene glycol diisocrotonate, pentaerythritol diisocrotonate, and sorbitol tetraisocrotonate.

Examples of the maleates include ethylene glycol dimaleate, triethylene glycol dimaleate, pentaerythritol dimaleate, and sorbitol tetramaleate.

Examples of other esters include aliphatic alcohol esters described in JP-B Nos.46-27926 and 51-47334, and JP-A No. 57-196231, those having an aromatic skeleton and described in JP-A Nos. 59-5240, 59-5241 and 2-226149, those containing an amino group and described in JP-A No. 1-165613. Moreover, any of the ester monomers described above may be used as a mixture.

Specific examples of the amide monomer of an aliphatic polyamine compound and an unsaturated carboxylic acid include methylenebis-acrylamide, methylenebis-methacrylamide, 1,6-hexamethylenebis-acrylamide, 1,6-hexamethylenebis-methacrylamide, diethylene triamine trisacrylamide, xylylenebis-acrylamide, and xylylenebis-methacrylamide. Other examples of preferred amide-monomers include those having a cyclohexylene structure and described in JP-B No. 54-21726.

Further, the polymerizable compound in the invention is also preferably an addition-polymerizable urethane compound produced by addition reaction of an isocyanate and a hydroxyl group-containing compound. Typical examples thereof include vinyl urethane compounds described in JP-B No. 48-41708. The vinyl urethane compounds contains two or more polymerizable vinyl groups in a molecule thereof, and are produced by adding a hydroxyl group-containing vinyl monomer represented by the Formula: CH₂=C(R ^{a})COOCH₂CH(R^{b})OH(wherein R^{a} and R^{b} each represent H or CH₃), to a polyisocyanate compound containing two or more isocyanate groups in a molecule thereof.

Further, urethane acrylates as described in JP-A No. 51-37193 and JP-B Nos. 2-32293 and 2-16765 and urethane compounds each having an ethylene oxide skeleton as described in JP-B Nos. 58-49860, 56-17654, 62-39417 and 62-39418 may also be suitably used as the polymerizable compound. Furthermore, when any of addition-polymerizable compounds each having an amino structure or a sulfide structure in a molecule thereof described in JP-A Nos. 63-277653, 63-260909 and 1-105238 is used as the polymerizable compound, a photopolymerizable composition that is considerably excellent in photosensitizing speed can be obtained.

Other examples of the polymerizable compound include multifunctional acrylates and methacrylates such as polyester acrylates as described in JP-A No. 48-64183, and JP-B Nos. 49-43191 and 52-30490, and epoxy acrylates obtained by reacting an epoxy resin with (meth)acrylic acid. Furthermore, specific unsaturated compounds described in JP-B Nos. 46-43946, 1-40337 and 1-40336, and vinylphosphonic acid compounds described in JP-A No. 2-25493 may also be used as the polymerizable compound. Moreover, in some instances, any of compounds having a structure with a perfluoroalkyl group, which described in JP-A No. 61-22048 may be appropriately used. In addition, any of photo-curable monomers and oligomers described in "Nippon Setchaku Kyokai Shi (Journal of Japanese Adhesive Society)", Vol. 20, No. 7, pages 300-308 (1984) may also be used.

Details of these addition-polymerizable compounds, for example, the structure thereof, and the method of use thereof such as use of only one of the compounds, use of two or more of the compounds, and the amount(s) of the compound(s) used, can be optionally determined depending on the desired performance of a final planographic printing plate precursor. For example, they are selected from the following viewpoints. From the viewpoint of photosensitizing speed, the addition-polymerizable compound preferably has a large number of unsaturated groups in one molecule, and in many cases, they are preferably bifunctional or more. In order to increase the intensity of the image portions, i.e. the cured layer, the addition-polymerizable compounds are preferably trifunctional or more. It is also effective to regulate both photosensitivity and intensity by combining compounds (e.g. acrylates, methacrylates, styrene compounds, and vinyl ether compounds) having different functionalities and different polymerizable groups. Although the high-molecular compounds or highly hydrophobic compounds have excellent photosensitizing speed and film strength, they may decelerate developing speed and tend to easily precipitate in the developing solution, and are not therefore preferably used in some cases. Selection and use of the addition-polymerizable compound is an important factor for compatibility between the compound and other components (e.g. a binder polymer, an initiator, and a coloring agent) and dispersibility thereof in the photosensitive layer compound. For example, the compatibility may be improved by using a compound having a low purity or a combination of two or more compounds.

A planographic printing plate precursor having a specific structure may be selected for the purpose of improving adhesiveness between the photosensitive layer and a protective layer or a support as described hereinafter .

The content of the addition-polymerizable compound in the photosensitive layer composition is preferably in a range of 5 to 80 % by weight and more preferably in a range of 40 to 75 % by weight relative to the solid content of the photosensitive layer composition, from the viewpoints of sensitivity, phase separation, adhesiveness of the photosensitive layer and a precipitating property of the addition-polymerizable compound in a developing solution.

One of these compounds may be used or two or more of them can be used together. In addition, as for use of the addition-polymerizable compound, the structure, the composition, and the addition amount thereof can be selected properly as needed, considering the extent of inhibition of polymerization caused by oxygen, resolution and the fogging property, change in refractive index, and surface adhesion. Further, a layer configuration containing an undercoat and/or an overcoat and a coating method of these coatings may also be applied to the planographic printing plate precursor of the invention.

### (binder polymer)

The binder polymer used in the invention has a function of improving layer properties, and therefore, any polymers that have a function of improving layer properties can be used as the binder polymer.

The binder polymer for use in the invention is preferably, for example, a binder polymer containing a crosslinkable group on the side chain (hereinafter, referred to as crosslinkable group-containing binder polymer).

The crosslinkable group is a group that crosslinks the binder polymer in the process of radical polymerization reaction occurring in the photosensitive layer when the planographic printing plate precursor is subjected to light exposure. The crosslinkable group is not particularly limited if it is a group having such a function, and examples thereof include groups having an ethylenically unsaturated bond group, amino group, epoxy group, or the like as the functional group capable of the addition polymerization. The crosslinkable group may also be a functional group that can be converted to a radical by photoirradiation, and examples of such functional groups include a thiol group, halogen groups, groups having an onium salt structure, and the like.

Among them, the crosslinkable group is preferably an ethylenically unsaturated bond group, and particularly preferably a functional group represented by the following Formulae (A) to (C).

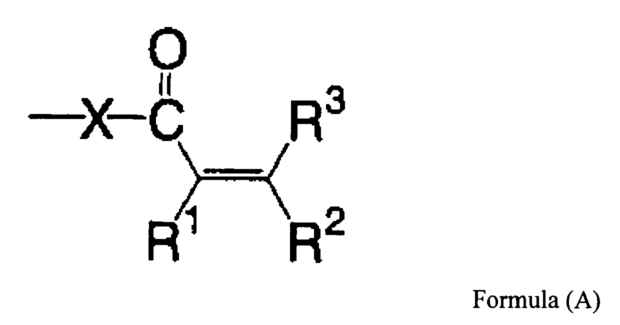

In formula (A), R¹ to R³ each independently represent a hydrogen atom or a monovalent substituent group of a non-metal atom.

R¹ is preferably a hydrogen atom or an alkyl group that may be substituted; and more preferable is a hydrogen atom or a methyl group, because of its high radical reactivity.

R² and R³ each independently represent a hydrogen or halogen atom, an amino, carboxyl, alkoxycarbonyl, sulfo, nitro, or cyano group, an alkyl group that may be substituted, an aryl group that may be substituted, an alkoxy group that may be substituted, an aryloxy group that may be substituted, an alkylamino group that may be substituted, an arylamino group that may be substituted, an alkylsulfonyl group that may be substituted, an arylsulfonyl group that may be substituted, or the like; and preferable is a hydrogen atom, a carboxyl group, an alkoxycarbonyl group, an alkyl group that may be substituted, or an aryl group that may be substituted, from the viewpoint of high radical reactivity.

X represents an oxygen or sulfur atom, or -N(R¹²)-; and R¹² represents a hydrogen atom or a monovalent organic group. R¹² may also be an alkyl group that may be substituted or the like, and preferable is a hydrogen atom or a methyl, ethyl, or isopropyl group, because of its high radical reactivity.

Examples of the substituents that may be introduced include alkyl groups, alkenyl groups, alkynyl groups, aryl groups, alkoxy groups, aryloxy groups, halogen atoms, an amino group, alkylamino groups, arylamino groups, a carboxyl group, alkoxycarbonyl groups, a sulfo group, a nitro group, a cyano group, amido groups, alkylsulfonyl groups, arylsulfonyl groups, and the like.

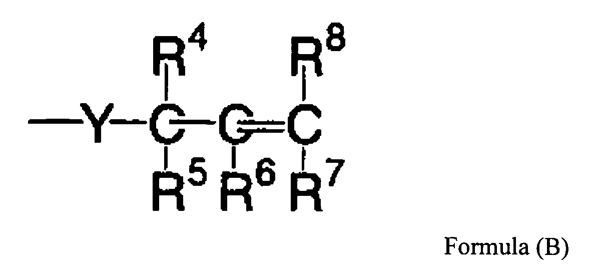

In formula (B), R⁴ to R⁸ each independently represent a hydrogen atom or a monovalent substituent group of a non-metal atom.

Each of R⁴ to R⁸ is preferably a hydrogen or halogen atom, an amino, dialkyl amino, carboxyl, alkoxycarbonyl, sulfo, nitro, or cyano group, an alkyl group that may be substituted, an aryl group that may be substituted, an alkoxy group that may be substituted, an aryloxy group that may be substituted, an alkylamino group that may be substituted, an arylamino group that may be substituted, an alkylsulfonyl group that may be substituted, an arylsulfonyl group that may be substituted, or the like; and preferably is a hydrogen atom, a carboxyl group, an alkoxycarbonyl group, an alkyl group that may be substituted, or an aryl group that may be substituted.

The substituents that may be introduced are, for example, those similar to the substituent groups described in formula (A). Y represents an oxygen or sulfur atom, or -N(R¹²)-. R¹² has the same definition as that for R¹² in formula (A), and the favorable examples thereof are also the same.

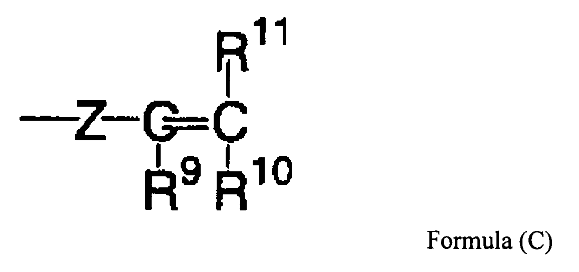

In formula (C), R⁹ to R¹¹each independently represent a hydrogen atom or a monovalent substituent group of a non-metal atom.

R⁹ is preferably a hydrogen atom, an alkyl group that may be substituted, or the like; and more preferable is a hydrogen atom or a methyl group, because of its high radical reactivity.

R¹⁰ and R¹¹ each independently represent a hydrogen or halogen atom, an amino, dialkylamino, carboxyl, alkoxycarbonyl, sulfo, nitro, or cyano group, an alkyl group that may be substituted, an aryl group that may be substituted, an alkoxy group that may be substituted, an aryloxy group that may be substituted, an alkylamino group that may be substituted, an arylamino group that may be substituted, an alkylsulfonyl group that may be substituted, an arylsulfonyl group that may be substituted, or the like; and more preferably is a hydrogen atom, a carboxyl group, an alkoxycarbonyl group, an alkyl group that may be substituted, or an aryl group that may be substituted, because of its high radical reactivity.

The substituents that may be introduced are, for example, those similar to the substituents described in formula (A). Z represents an oxygen or sulfur atom, -N(R¹³)-, or a phenylene group that may be substituted. R¹³ may be, for example, an alkyl group that may be substituted; and preferable is a methyl, ethyl, or isopropyl group, because of its high radical reactivity.

The crosslinkable group-containing binder polymer should not only function as a film-forming agent in the photosensitive layer, but also should be soluble in developing solution, in particular, in alkaline developing solution, and thus, an organic polymer soluble or swelling in alkaline water is preferable.

Accordingly, the crosslinkable group-containing binder polymer in the invention preferably has an alkali-soluble group on the side chain as well as a crosslinkable group.

The alkali-soluble group contained in the crosslinkable group-containing binder polymer is preferably an alkali-soluble group selected from the group consisting of the following functional groups (1) to (6), from the viewpoint of solubility of the binder polymer in alkaline developing solution, and the binder polymer preferably has a structural unit containing at least one of the alkali-soluble groups the above.
(1) Phenolic hydroxyl group (-Ar-OH)
(2) Sulfonamide group (-SO₂NH-R
(3) Substituted sulfonamide-based acidic group (hereinafter, referred to as "active imide group")

   (-SO₂NHCOR -SO₂NHS0₂R, -CONHSO₂R)
(4) Carboxylic acid group (-CO₂H
(5) Sulfonic acid group (-SO₃H)
(6) Phosphoric acid group (-OPO₃H₂)

In the functional groups (1) to (6), Ar represents a bivalent aryl connecting group that may have a substituent; and R represents a hydrogen atom or a hydrocarbon group that may have a substituent.

The structural unit having an alkali-soluble group (acidic group) selected from the functional groups (1) to (6) may be not only a single structural unit, but also a copolymer of two or more structural units that have the same acidic group but are different from each other or a copolymer of two or more structural units each having a different acidic group.

A repeating unit represented by Formula (i) described below may be used as the structural unit having a carboxylic acid group (4).

In another preferable embodiment, a binder polymer having a repeating unit represented by the following Formula (i) is used as the binder polymer in the invention. Hereinafter, the binder polymer having a repeating unit represented by Formula (i) will be referred to as specific binder polymer and will be described in detail hereinafter.

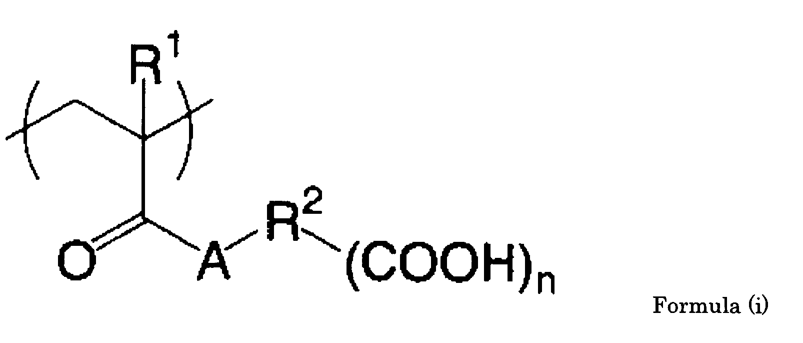

In formula (i), R¹ represents a hydrogen atom or a methyl group; R² represents a connecting group which includes two or more atoms selected from the group consisting of a carbon atom, a hydrogen atom, an oxygen atom, a nitrogen atom and a sulfur atom and which has 2 to 82 atoms in total; A represents an oxygen atom or NR³-; R³ represents a hydrogen atom or a monovalent hydrocarbon group having 1 to 10 carbon atoms; and n represents an integer of 1 to 5.

R¹ in formula (i) represents a hydrogen atom or a methyl group, and is more preferably a methyl group.

The connecting group represented by R² in formula (i) contains two or more atoms selected from the group consisting of a carbon atom, a hydrogen atom, an oxygen atom, a nitrogen atom, and a sulfur atom. The connecting group has 2 to 82 atoms in total, preferably has 2 to 50 atoms in total, and more preferably has 2 to 30 atoms in total. If the connecting group has at least one substituent, the total number of atoms includes the number of atoms of the substituent(s). More specifically, the number of atoms consisting the main skeleton of the connecting group represented by R² is preferably 1 to 30, more preferably 3 to 25, still more preferably 4 to 20, and most preferably 5 to 10. The term "main skeleton of the connecting group" refers to an atom or an atomic group connecting "A" and the terminal COOH group in formula (i). In particular, when the connecting group has a plurality of connecting routes, the main skeleton of the connecting group refers to an atom or an atomic group forming the shortest connection between "A" and the terminal COOH group. Accordingly, when the connecting group includes a cyclic structure therein, number of the atoms to be counted may vary depending on the connecting position (e.g., ortho, meta, or para).

Specific examples of the connecting group include substituted or unsubstituted alkylene, substituted or unsubstituted arylene, and groups in which these bivalent groups are connected via at least one amide or ester bond.

Examples of connecting groups having a chain structure include ethylene, and propylene. Connecting groups in which these alkylenes are connected to each other via at least one ester bond is also preferably used.

The connecting group represented by R² in formula (i) is preferably a hydrocarbon group having an alicyclic structure with 3 to 30 carbon atoms and a valence of (n+1). Specific examples of such a compound include hydrocarbon groups having a valence of (n+1) and obtained by removing (n+1) hydrogen atoms each bonding to one of carbon atoms of an alicyclic hydrocarbon compound, such as cyclopropane, cyclopentane, cyclohexane, cycloheptane, cyclooctane, cyclodecane, dicyclohexyl, tercyclohexyl, and norbornane, which may have at least one substituent. In addition, R² preferably has 3 to 30 carbon atoms which include carbon atoms of the substituent(s).

One or more carbon atoms of the compound having an alicyclic structure may optionally be substituted by at least one hetero atom selected from a nitrogen atom, an oxygen atom and a sulfur atom. In view of printing durability, R² is preferably a hydrocarbon group which has an alicyclic structure and a valence of (n+1), which may have a substituent, and which has 5 to 30 carbon atoms and includes two or more rings, such as a condensed polycyclic aliphatic hydrocarbon, a crosslinked alicyclic hydrocarbon, a spiro aliphatic hydrocarbon or compounds having aliphatic hydrocarbon rings connected with each other via a bond or a connecting group. Also in this instance, the number of carbon atoms involves the number of carbon atoms included in the substituent(s).

The connecting group represented by R² is particularly preferably a group containing a main skeleton with 5 to 10 carbon atoms. Such a compound preferably has a chain structure containing at least one ester bond in the structure thereof or the cyclic structure described above.

Examples of the substituent which may be introduced into the connecting group represented by R² include monovalent non-metal atomic groups excluding hydrogen, such as halogen atoms (-F, -Br, -Cl and -I), a hydroxyl group, alkoxy groups, aryloxy groups, a mercapto group, alkylthio groups, arylthio groups, alkyldithio groups, aryldithio groups, an amino group, N-alkylamino groups, N,N-dialkylamino groups, N-arylamino groups, N,N-diarylamino groups, N-alkyl-N-arylamino groups, acyloxy group, a carbamoyloxy group, N-alkylcarbamoyloxy groups, N-arylcarbamoyloxy groups, N,N-dialkylcarbamoyloxy groups, N,N-diarylcarbamoyloxy groups, N-alkyl-N-arylcarbamoyloxy groups, alkylsulfoxy groups, arylsulfoxy groups, acylthio groups, acylamino groups, N-alkylacylamino groups, N-arylacylamino groups, an ureido group, N'-alkylureido groups, N',N'-dialkylureido groups, N'-arylureido groups, N',N'-diarylureido groups, N'-alkyl-N'-arylureido groups, N-alkylureido groups, N-arylureido groups, N'-alkyl-N-alkylureido groups, N'-alkyl-N-arylureido groups, N',N'-dialkyl-N-alkylureido groups, N',N'-dialkyl-N-arylureido groups, N'-aryl-N-alkylureido groups, N'-aryl-N-arylureido groups, N',N'-diaryl-N-alkylureido groups, N',N'-diaryl-N-arylureido groups, N'-alkyl-N'-aryl-N-alkylureido groups, N'-alkyl-N'-aryl-N-arylureido groups, alkoxycarbonylamino groups, aryloxycarbonylamino groups, N-alkyl-N-alkoxycarbonylamino groups, N-alkyl-N-aryloxycarbonylamino groups, N-aryl-N-alkoxycarbonylamino groups, N-aryl-N-aryloxycarbonylamino groups, a formyl group, acyl groups, a carboxyl group and conjugated base groups thereof, alkoxycarbonyl groups, aryloxycarbonyl groups, a carbamoyl group, N-alkylcarbamoyl groups, N,N-dialkylcarbamoyl groups, N-arylcarbamoyl groups, N,N-diarylcarbamoyl groups, N-alkyl-N-arylcarbamoyl groups, alkylsulfinyl groups, arylsulfinyl groups, alkylsulfonyl groups, arylsulfonyl groups, a sulfo group (-SO₃H) and conjugated base groups thereof, alkoxysulfonyl groups, aryloxysulfonyl groups, a sulfinamoyl group, N-alkylsulfinamoyl groups, N,N-dialkylsulfinamoyl groups, N-arylsulfinamoyl groups, N,N-diarylsulfinamoyl groups, N-alkyl-N-arylsulfinamoyl groups, a sulfamoyl group, N-alkylsulfamoyl groups, N,N-dialkylsulfamoyl groups, N-arylsulfamoyl groups, N,N-diarylsulfamoyl groups, N-alkyl-N-arylsulfamoyl groups, N-acylsulfamoyl groups and conjugated base groups thereof, N-alkylsulfonylsulfamoyl groups (-SO₂NHSO₂(alkyl)) and conjugated base groups thereof, N-arylsulfonylsulfamoyl groups (-SO₂NHSO₂(aryl)) and conjugated base groups thereof, N-alkylsulfonylcarbamoyl groups (-CONHSO₂(alkyl) and conjugated base groups thereof, N-arylsulfonylcarbamoyl groups (-CONHSO₂(aryl) and conjugated base groups thereof, alkoxysilyl groups (-Si(Oalkyl)₃), aryloxysilyl groups (-Si(Oaryl)₃), a hydroxysilyl group (-Si(OH)₃) and conjugated base groups thereof, a phosphono group (-PO₃H₂) and conjugated base groups thereof, dialkylphosphono groups (-PO₃ (alkyl)₂), diarylphosphono groups (-PO₃(aryl)₂), alkylarylphosphono groups (-PO₃(alkyl)(aryl)), monoalkylphosphono groups (-PO₃H(alkyl)) and conjugated base groups thereof, monoarylphosphono groups (-PO₃H(aryl)) and conjugated base groups thereof, a phosphonoxy group (-OPO₃H₂) and conjugated base groups thereof, dialkylphosphonoxy groups (-OPO₃ (alkyl)₂), diarylphosphonoxy groups (-OPO₃(aryl)₂), alkylarylphosphonoxy groups (-OPO₃(alkyl)(aryl)), monoalkylphosphonoxy groups (-OPO₃H(alkyl)) and conjugated base groups thereof, monoarylphosphonoxy groups (-OPO₃H(aryl)) and conjugated base groups thereof, a cyano group, a nitro group, dialkylboryl groups (-B(alkyl)₂), diarylboryl groups (-B(aryl)₂), alkylarylboryl groups (-B(alkyl)(aryl)), a dihydroxyboryl group (-B(OH)₂) and conjugated base groups thereof, alkylhydroxyboryl groups (-B(alkyl)(OH)) and conjugated base groups thereof, arylhydroxyboryl groups (-B(aryl)(OH)) and conjugated base groups thereof, aryl groups, alkenyl groups, and alkynyl groups.

In the planographic printing plate precursor of the invention, substituents having at least one hydrogen atom capable of forming a hydrogen bond, particularly, substituents having a smaller value of acid dissociation constant (pKa) than that of carboxylic acid are not preferred, because they are likely to reduce printing durability. However, such substituents may be used depending on the design of the photosensitive layer. On the contrary, halogen atoms, hydrophobic substituents such as hydrocarbon groups (e.g., alkyl groups, aryl groups, alkenyl groups and alkynyl groups), alkoxy groups and aryloxy groups are preferred because they are likely to improve printing durability. In particular, when the cyclic structure is a mono-alicyclic hydrocarbon with a ring skeleton having 6 or less atoms, such as cyclopentane or cyclohexane, it preferably has the aforementioned hydrophobic substituent(s). These substituents may bind each other to form a ring, or may bind to the hydrocarbon group that has a substituent to form a ring, if possible. In addition, the substituent may have a substituent.

When A in formula (i) is NR³-, R³ represents a hydrogen atom or a monovalent hydrocarbon group having 1 to 10 carbon atoms. The monovalent hydrocarbon groups having 1 to 10 carbon atoms and represented by R³ include alkyl groups, aryl groups, alkenyl groups, and alkynyl groups.

Typical examples of the alkyl groups include linear, branched, and cyclic alkyl groups having 1 to 10 carbon atoms, such as a methyl group, an ethyl group, a propyl group, a butyl group, a pentyl group, a hexyl group, a heptyl group, an octyl group, a nonyl group, a decyl group, an iso-propyl group, an iso-butyl group, a sec-butyl group, a tert-butyl group, an iso-pentyl group, a neopentyl group, a 1-methylbutyl group, an iso-hexyl group, a 2-ethylhexyl group, a 2-methylhexyl group, a cyclopentyl group, a cyclohexyl group, a 1-adamantyl group, and a 2-norbornyl group.

Typical examples of the aryl groups include aryl groups having 1 to 10 carbon atoms such as a phenyl group, a naphthyl group, and an indenyl group; and hetero aryl groups having 1 to 10 carbon atoms and containing at least one hetero atom selected from the group consisting of a nitrogen atom, an oxygen atom and a sulfur atom, such as a furyl group, a thienyl group, a pyrrolyl group, a pyridyl group, and a quinolyl group.

Typical examples of the alkenyl groups include linear, branched, and cyclic alkenyl groups having 1 to 10 carbon atoms, such as a vinyl group, a 1-propenyl group, a 1-butenyl group, a 1-methyl-1-propenyl group, a 1-cyclopentenyl group, and a 1-cyclohexenyl group.

Typical examples of the alkynyl groups include alkynyl groups having 1 to 10 carbon atoms, such as an ethynyl group, a 1-propynyl group, a 1-butynyl group, and a 1-octynyl group. R³ may have at least one substituent, and examples of the substituent are the same as those of the substituent which can be introduced into R². However, the total number of carbon atoms of R³ including the number of carbon atoms of the substituent(s) is 1 to 10.

"A" in formula (i) is preferably an oxygen atom or -NH-, from the viewpoint of easy synthesis of the compound.

Typical examples of the repeating unit represented by formula (i) are shown below, but the invention is not limited thereto.

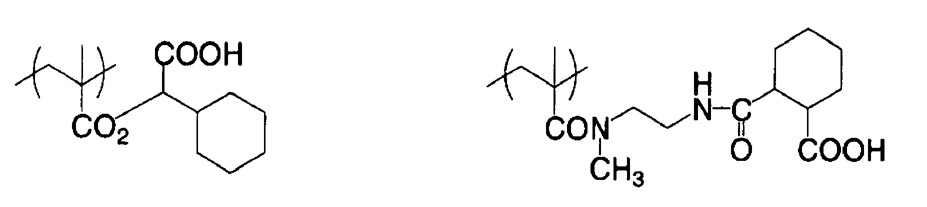

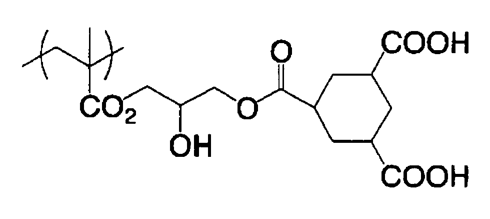

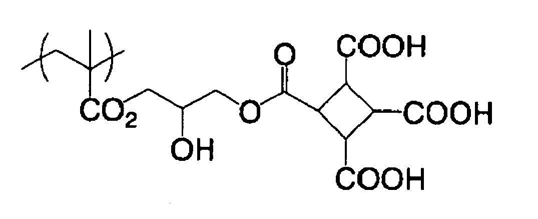

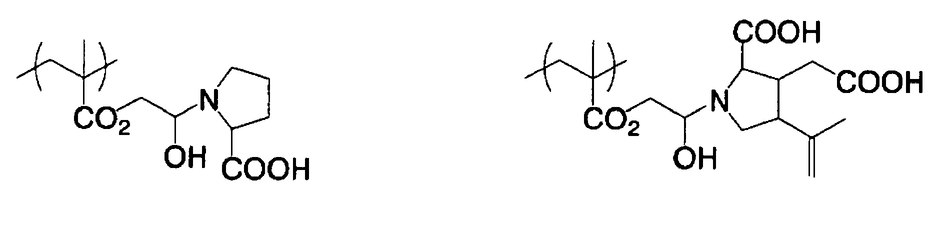

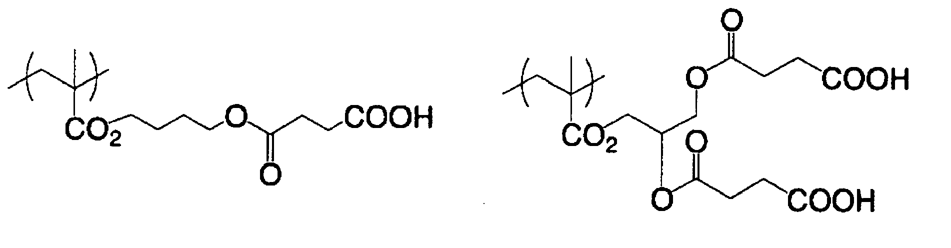

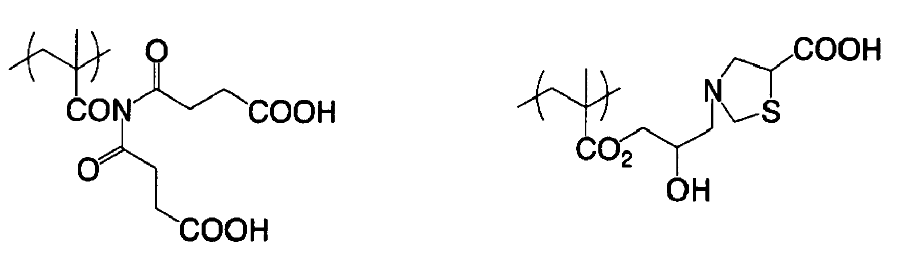

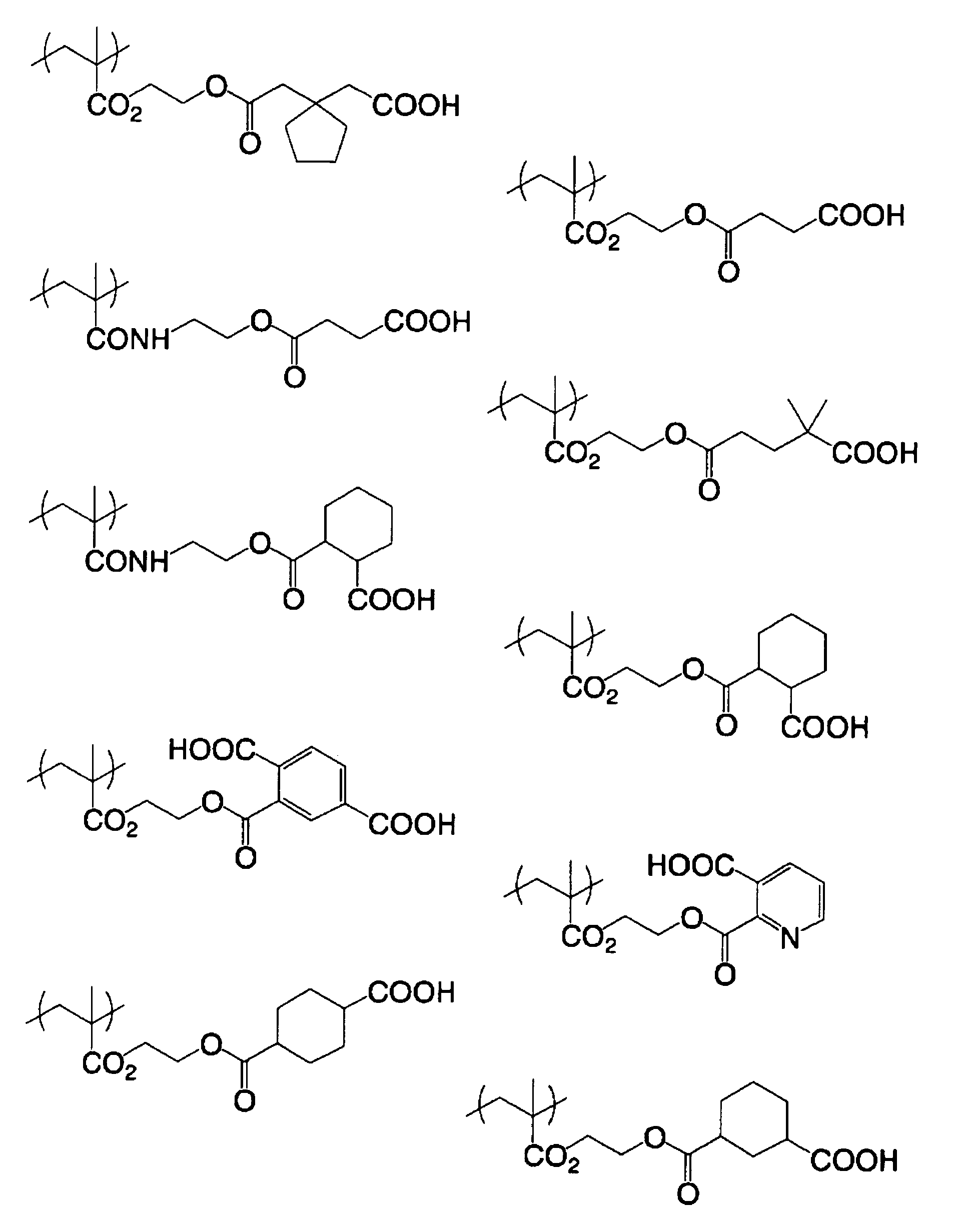

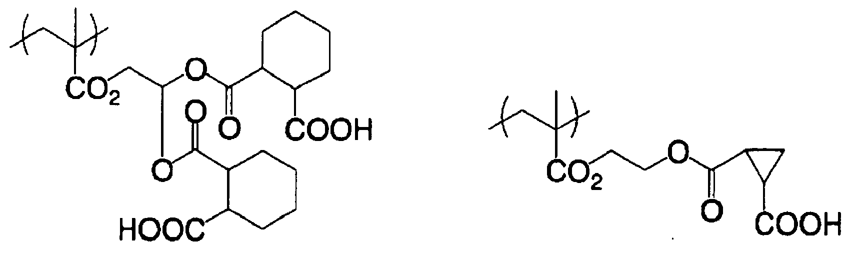

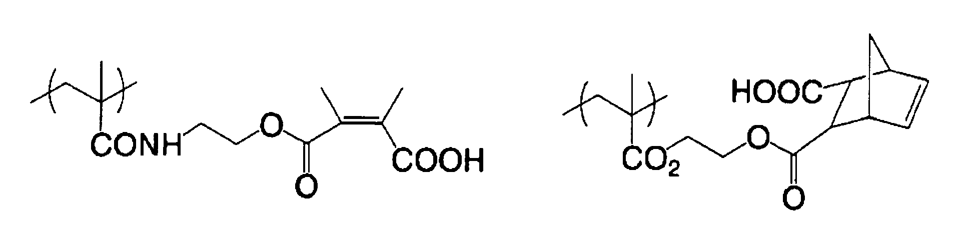

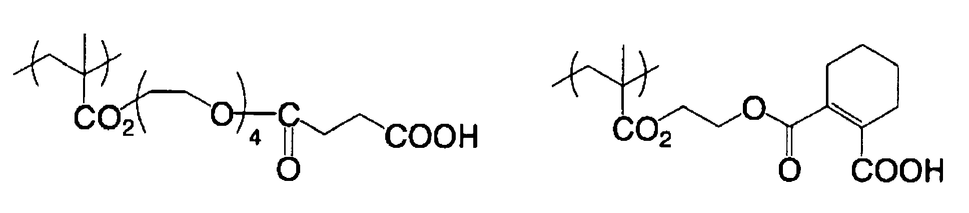

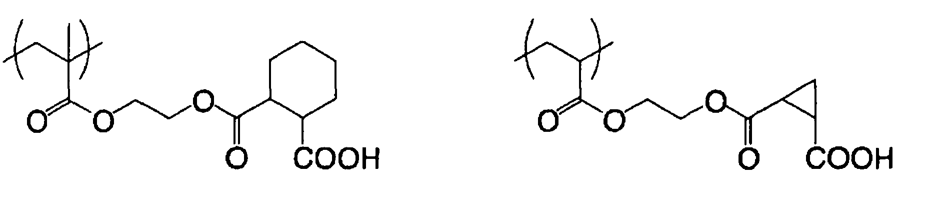

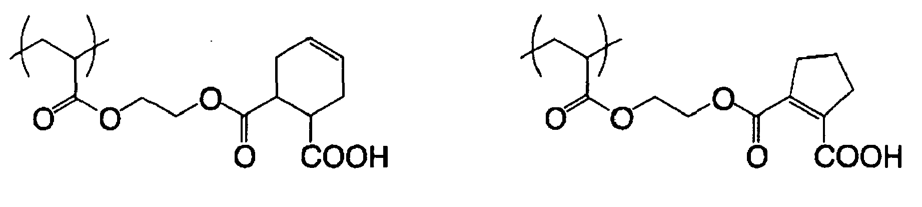

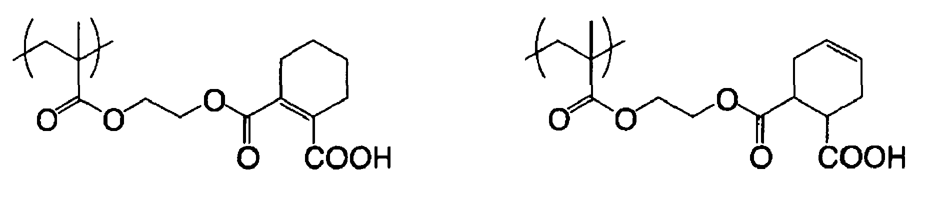

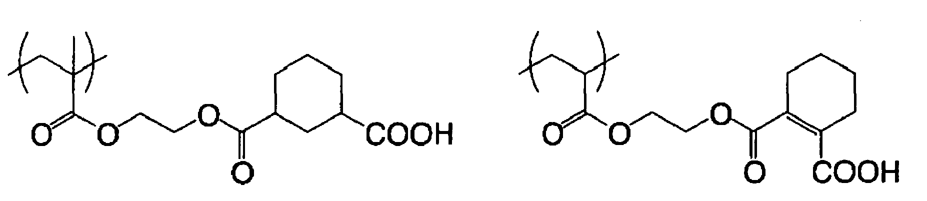

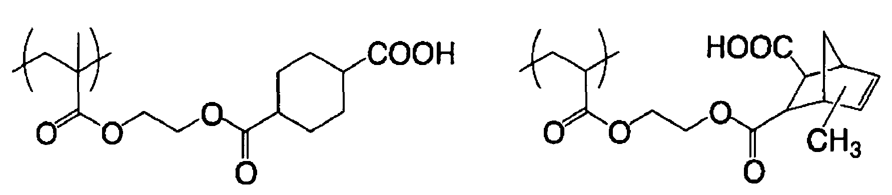

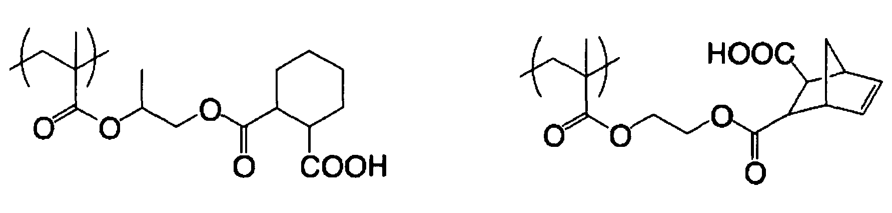

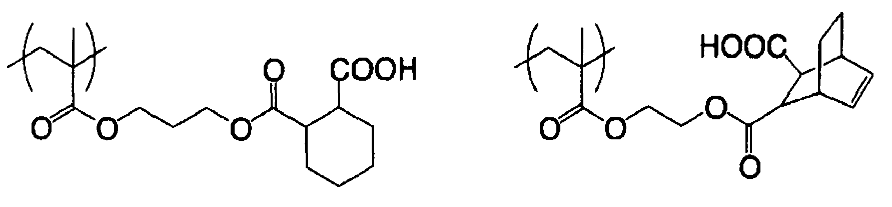

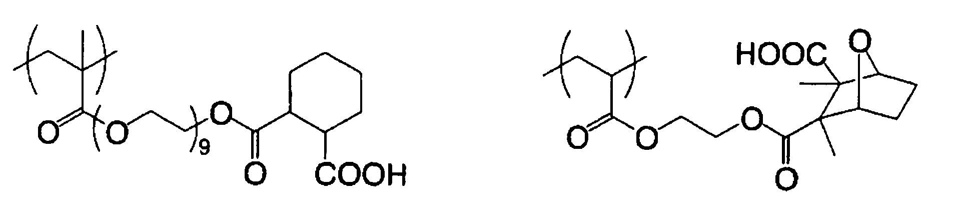

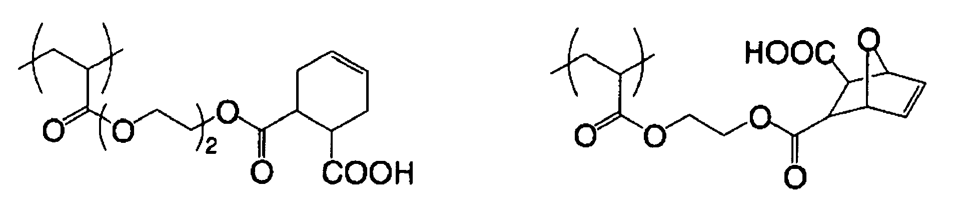

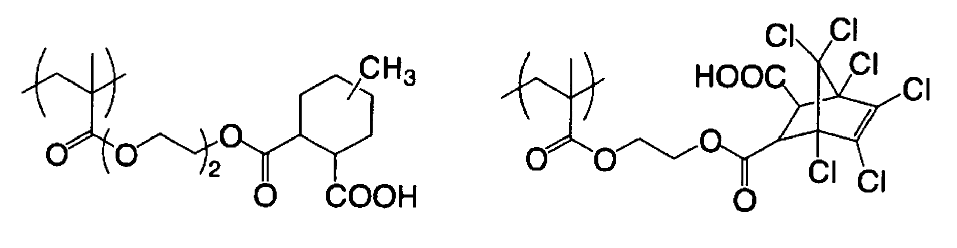

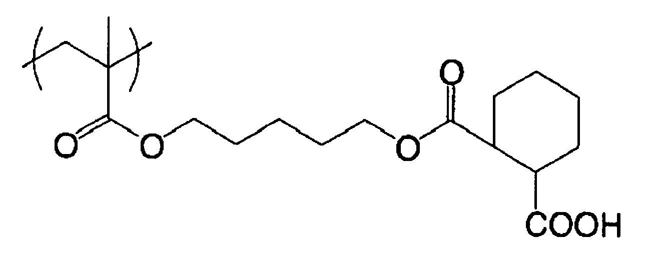

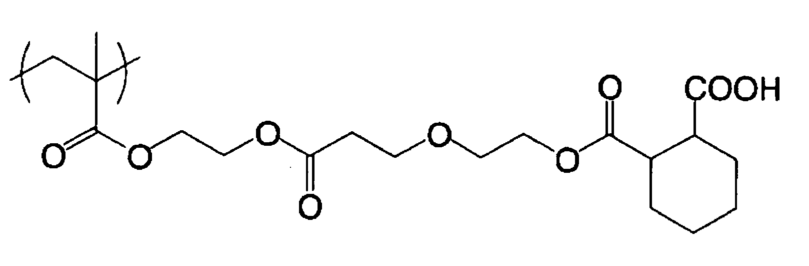

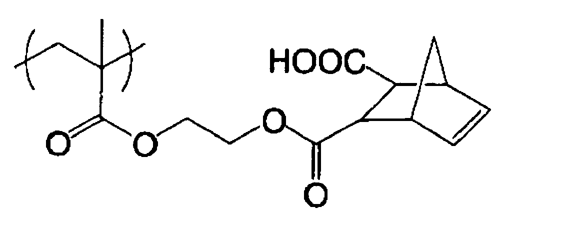

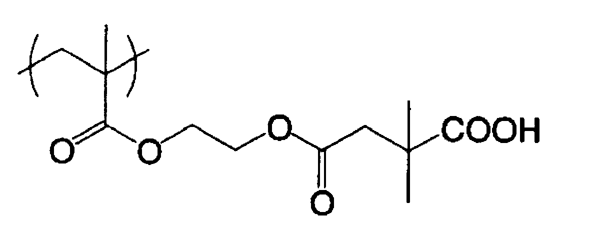

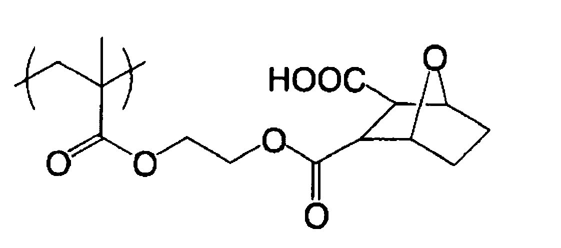

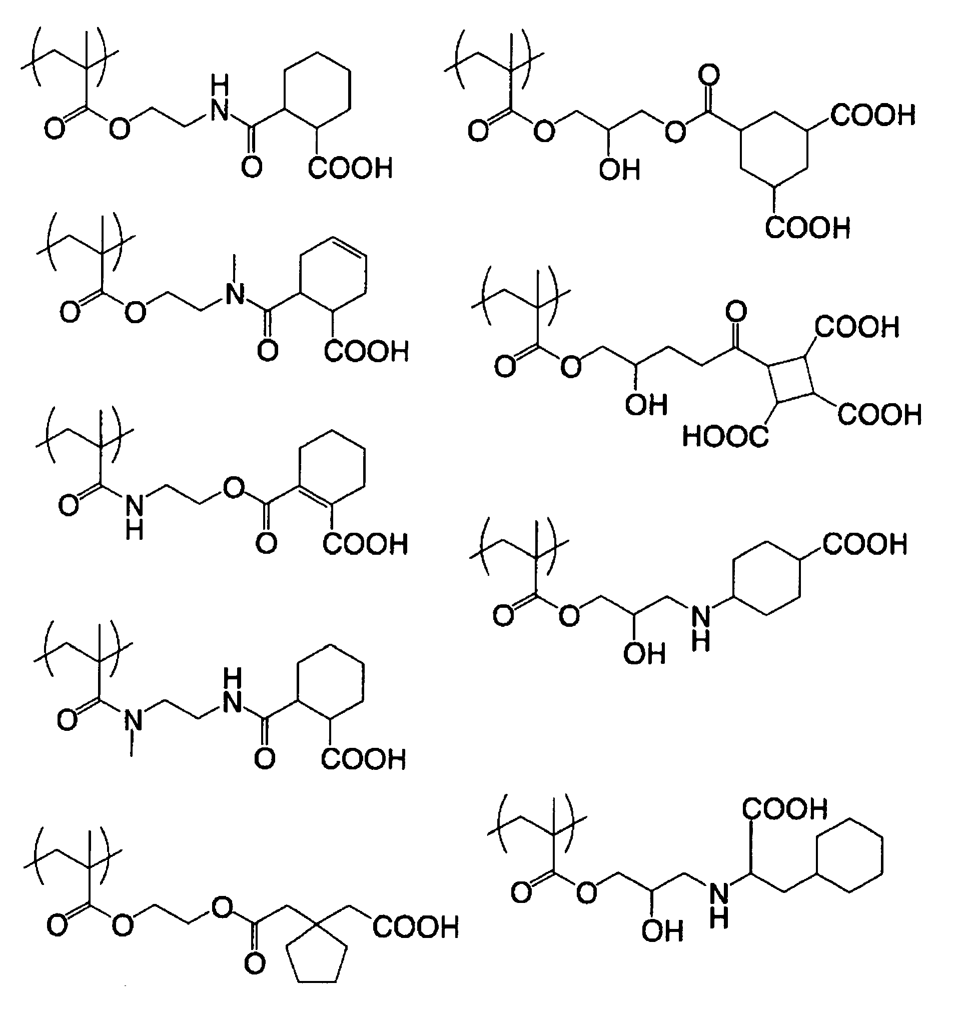

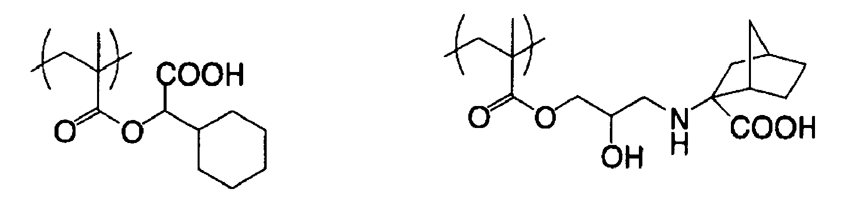

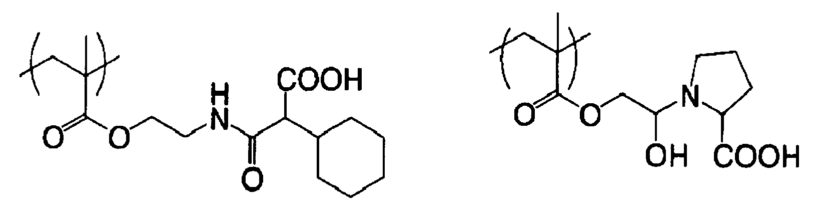

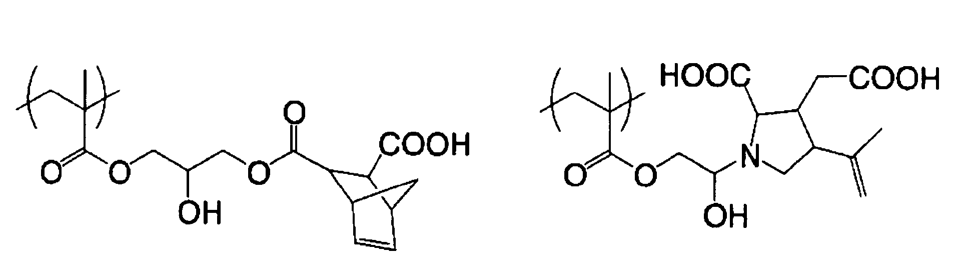

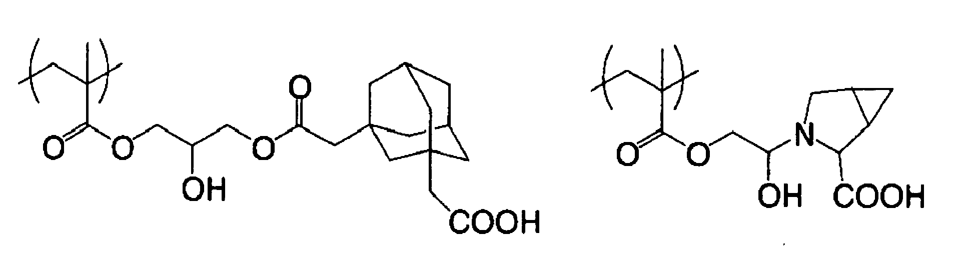

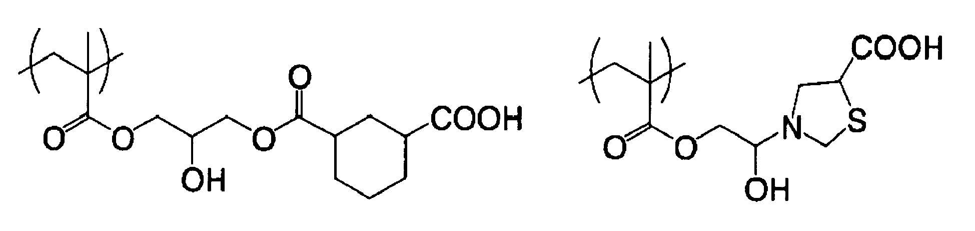

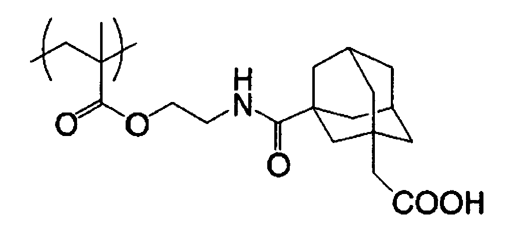

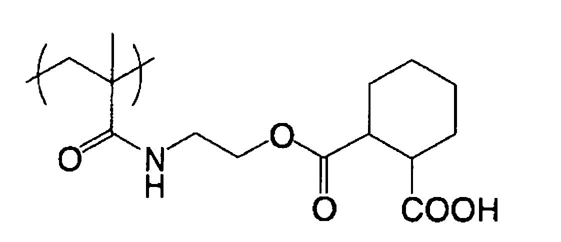

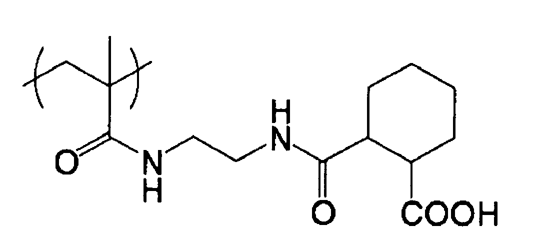

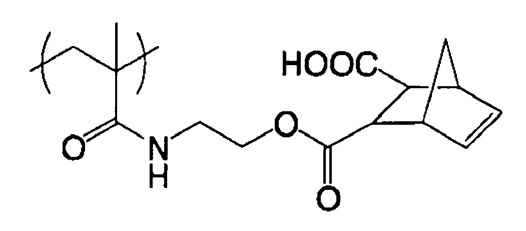

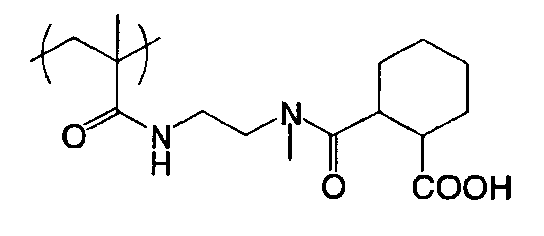

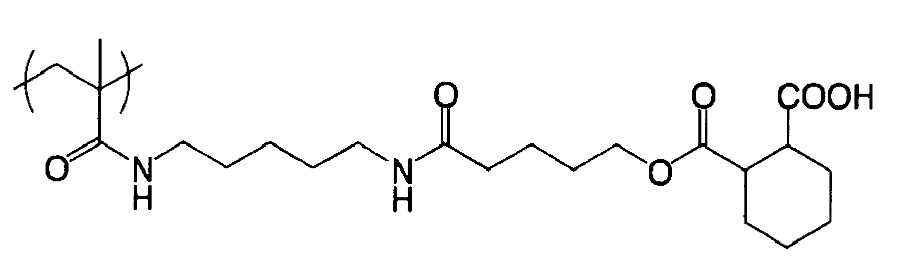

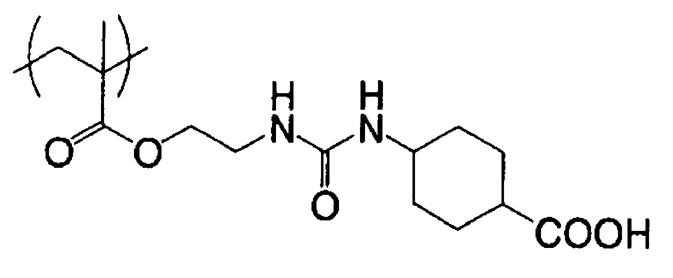

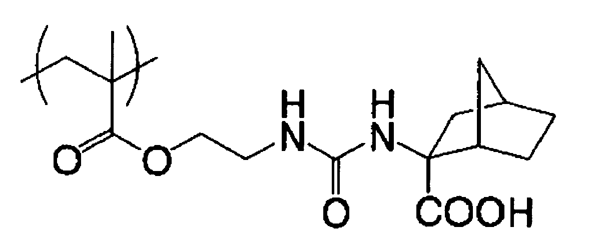

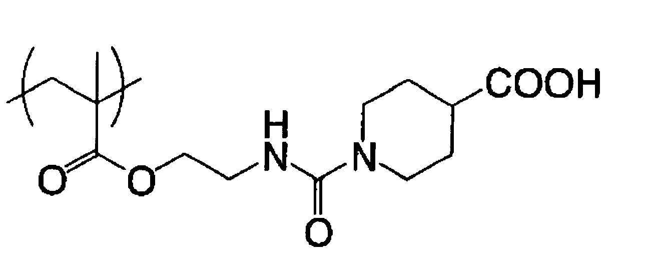

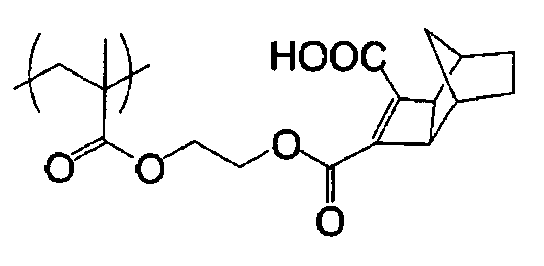

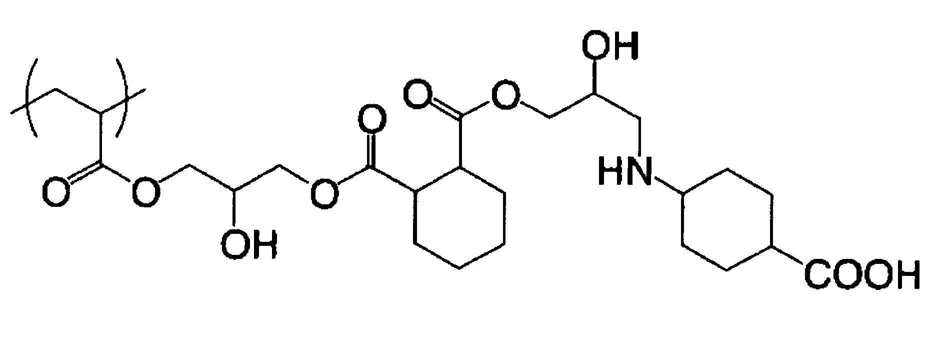

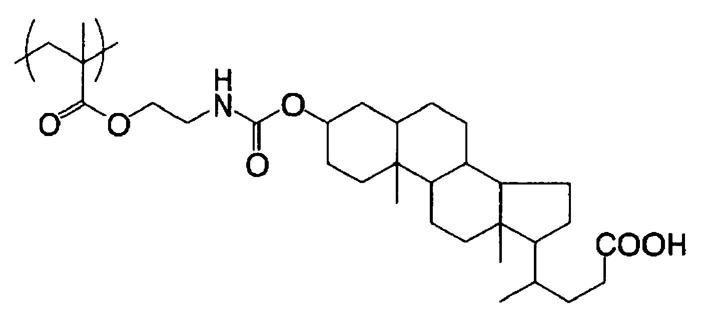

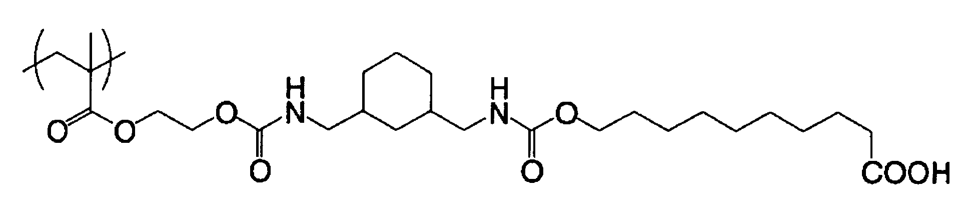

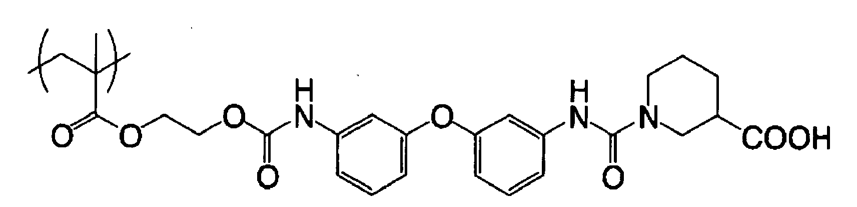

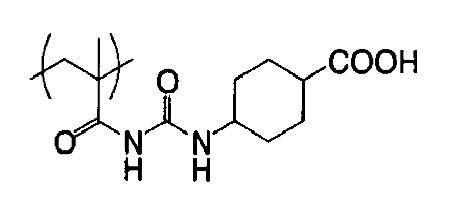

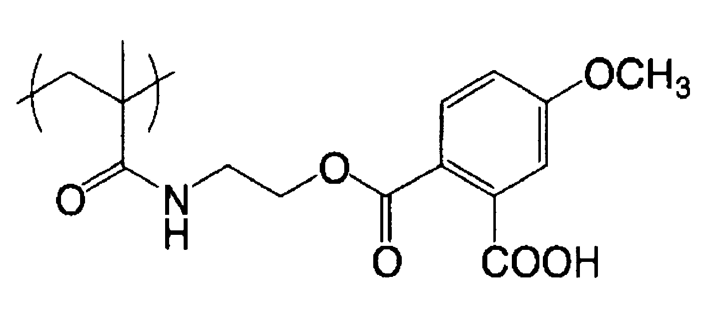

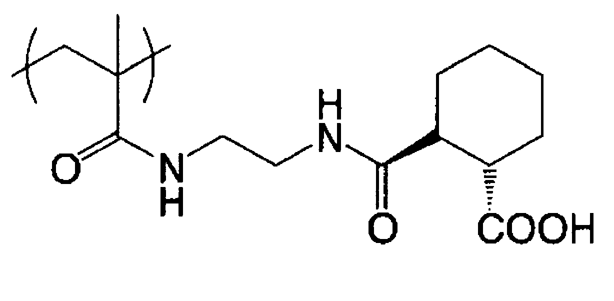

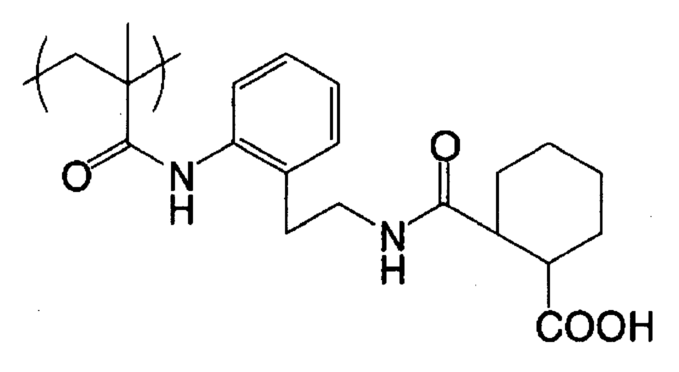

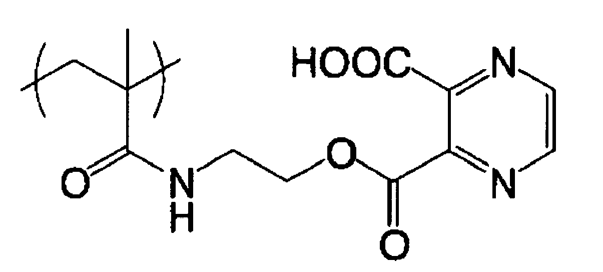

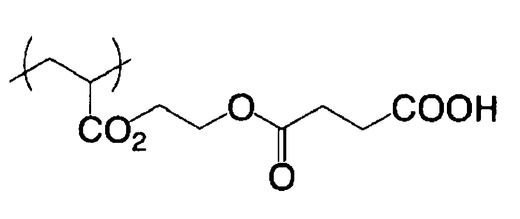

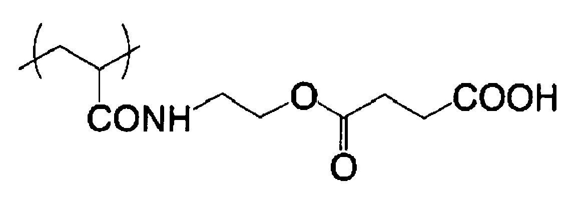

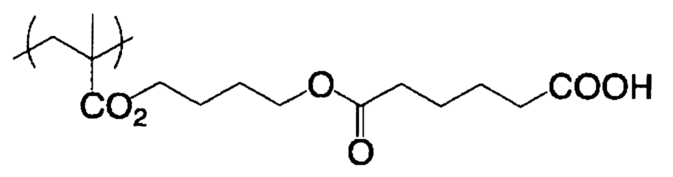

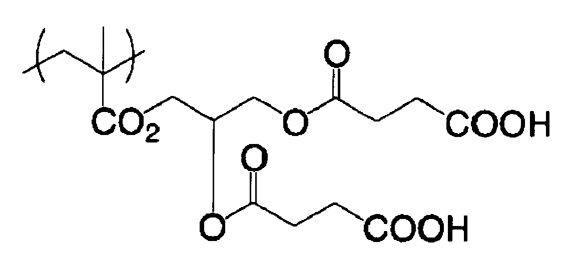

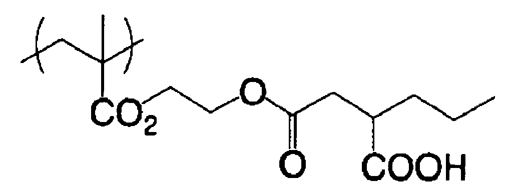

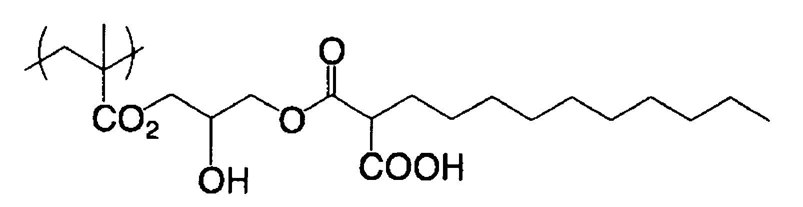

The binder polymer may have one or more repeating units represented by formula (i). The specific binder polymer used in the invention may be a polymer consisting of the repeating unit represented by formula (i), but is usually used as a copolymer in combination with any other copolymerizable component. A desired total content of the repeating unit represented by formula (i) in the copolymer is suitably determined from a desired structure of the polymer, and a desired composition for a photosensitive layer, but the total content is preferably in a range of 1 to 99 mole %, more preferably 5 to 40 mole %, and still more preferably 5 to 20 mole % relative to the total mole of the polymer components.

When the binder polymer is a copolymer, the copolymerizable component to be used may be any conventionally known monomer that is a radically polymerizable monomer. Specific examples include monomers described in "Kobunshi Data Handbook (Polymer Data Handbook), Kiso-hen (Fundamental Step) edited by Kobunshi Gakkai (Society of Polymer Science, Japan), published by BAIFUKAN CO., LTD in 1986)". One of the copolymerizable components may be used or two or more of them can be used together.

A desired molecular weight of the specific binder polymer used in the invention is determined suitably, considering the image-forming property and printing durability of the precursor. The molecular weight is preferably in a range of 2,000 to 1,000,000, more preferably in a range of 5,000 to 500,000, and still more preferably in a range of 10,000 to 200,000.

One of the specific binder polymers may be used alone or one of crosslinkable group-containing binder polymers may be used alone or; or alternatively, both of the specific binder polymer and the crosslinkable group-containing binder polymer may be used in combination. Yet alternatively, another binder polymer may be used, or another binder polymer may be used in combination with the specific binder polymer or the crosslinkable group-containing binder polymer.

The other binder polymer is preferably used in an amount of 1 to 60 wt %, more preferably 1 to 40 wt %, and still more preferably 1 to 20 wt %, relative to the total amount of the binder polymer components.

A desired total content of the binder polymers in the photosensitive layer composition may be appropriately determined, but the total content is usually in a range of 10 to 90 % by weight, preferably 20 to 80 % by weight, and still more preferably 30 to 70 % by weight relative to the total weihgt of the non-volatile components in the photosensitive layer composition.

In addition, the acid value (meg/g) of the binder polymer is preferably in a range of 2.00 to 3.60.

### (Other binder polymers usable together with the specific binder polymer)

Any one of known binder polymers, specifically, an acrylic main-chained binder, an urethane binder, or the like, which is commonly used in the art, may be used as the other binder polymer for use in combination with the specific binder polymer or the crosslinkable group-containing binder polymer described above.

Use of a binder polymer containing a radically polymerizable group as the other binder polymer is also preferable.

The radically polymerizable group is not particularly limited, as long as it is radically polymerized. Examples thereof include α-substituted-methylacryl groups (-OC(=O)-C(-CH₂Z)=CH₂ wherein Z is a hydrocarbon group with a hetero atom bonding to -CH₂ group), acrylic groups, methacrylic groups, allyl groups, and styryl groups. The radically polymerizable group is preferably an acrylic group or a methacrylic group.

The content of the radically polymerizable group(s) in the binder polymer, more specifically, the content of the radically polymerizable unsaturated double bonds determined by iodimetry, is preferably 0.1 to 10.0 mmol, more preferably 1.0 to 7.0 mmol, and most preferably 2.0 to 5.5 mmol per gram of the binder polymer, from the viewpoints of sensitivity and storage stability.

In addition, it is preferable that other binder polymer further has an alkali-soluble group. The content of the alkali-soluble group(s) in the binder polymer, in other words, the acid value of the binder polymer determined by neutralization titration, is preferably 0.1 to 3.0 mmol, more preferably 0.2 to 2.0 mmol, and most preferably 0.45 to 1.0 mmol per gram of the binder polymer, from the viewpoints of precipitation of development scums and printing durability.

The weight-average molecular weight of the binder polymer is preferably in a range of 2,000 to 1,000,000, more preferably in a range of 10,000 to 300,000, and most preferably in a range of 20,000 to 200,000, from the viewpoints of the film-forming property (printing durability) of the binder polymer and the solubility of the binder polymer in a coating solvent.

Further, the glass transition temperature (Tg) of the binder polymer is preferably in a range of 70 to 300°C, more preferably in a range of 80 to 250°C, and particularly preferably in a range of 90 to 200°C, from the viewpoints of storage stability, printing durability, and sensitivity.

The binder polymer preferably has an amide or imide group in the molecule thereof, and more preferably has a methacrylamide or a methacrylamide derivative, in order to raise the glass transition temperature of the binder polymer.

### (Other components)

The photosensitive layer of the invention may contain not only the aforementioned essential components but also any other component which is suitable for the intended use, and the production method, if necessary. Preferred additives will be described below.

### -Colorant-

A dye or pigment may be added to the photosensitive layer in the invention, for coloring the layer. It is thus possible to improve so-called plate-checking properties such as the visibility of printing plates after plate-making and the applicability for image densitometer. Typical examples of the colorants include pigments such as phthalocyanine pigments, azo pigments, carbon black, and titanium oxide and dyes such as ethyl violet, crystal violet, azo dyes, anthraquinone dyes, cyanine dyes; and among them, cationic dyes are preferable. The amount of the colorant (dye or pigment) added is preferably approximately 0.5 to 5 wt % relative to the total amount of nonvolatile components in the entire photosensitive layer composition.

### -Polymerization Inhibitor-

It is preferable that the photosensitive layer of the invention contains a small amount of a thermal polymerization inhibitor in order to inhibit undesired thermal polymerization of the compound having a polymerizable ethylenically unsaturated double bond, namely the polymerizable compound. Examples of the thermal polymerization inhibitor include hydroquinone, p-methoxyphenol, di-t-butyl-p-cresol, pyrogallol, t-butylcatechol, benzoquinone, 4,4'-thiobis(3-methyl-6-t-butylphenol), 2,2'-methylenebis(4-methyl-6-t-butylphenol), and a primary cerium salt of N-nitrosophenylhydroxylamine. The amount of the thermal polymerization inhibitor added is preferably about 0.01 to about 5 % by weight relative to the total weight of the nonvolatile components contained in the photosensitive layer composition. In order to prevent oxygen from inhibiting the polymerization, the photosensitive layer composition may also contain a higher fatty acid derivative such as behenic acid or behenic acid amide, which is made to exist mainly at the surface of the layer during drying of the applied coating, if necessary. The amount of the higher fatty acid derivative added is preferably about 0.5 to about 10 % by mass relative to the mass of the nonvolatile components contained in the photosensitive layer composition.

### -Other additives-

In addition, the photosensitive layer in the invention may contain any other known additives such as an inorganic filler for improving the physical properties of a cured film, a plasticizer, and a sensitizing agent for improving a surface property of the photosensitive layer by which an ink easily adheres to the layer surface. Examples of the plasticizer include dioctyl phthalate, didodecyl phthalate, triethylene glycol dicaprylate, dimethyl glycol phthalate, tricresyl phosphate, dioctyl adipate, dibutyl sebacate, and triacetylglycerin. The content of such a plasticizer is generally in a range of 10 % by weight or less, relative to the total weight of the binder polymer and the addition-polymerizable compound.

Further, the photosensitive layer in the invention may contain a UV initiator, and/or a thermal crosslinking agent in order to enhance the effects of heating and exposure of the developed layer and in turn improve the film strength (printing durability) described hereinafter.

### (Support)

As the support used in the invention, a hydrophilized support is used as described hereinafter. The support is preferably paper, a polyester film, or an aluminum plate, and more preferably an aluminum plate, which is superior in dimensional stability and relatively cheap, and whose surface can be provided with superior hydrophilicity and strength by a surface treatment as needed. In addition, the support is also preferably a composite sheet in which an aluminum sheet is laminated on a polyethylene terephthalate film, such as those disclosed in JP-B No. 48-18327.

The aluminum plate as particularly preferable support in the invention is a metal plate containing aluminum, which has dimensional stability, as the primary component thereof, and examples thereof include a pure aluminum plate, an alloy plate containing aluminum as the primary component and a trace amount of element(s) other than aluminum, and plastic films and paper on which aluminum or an aluminum alloy is laminated or vapor-deposited. A support made of aluminum or an aluminum alloy described above is called as an aluminum support hereinafter. Examples of elements other than aluminum which may be contained in the aluminum alloy include silicon, iron, manganese, copper, magnesium, chromium, zinc, bismuth, nickel, and titanium. The content of such an element or elements in the alloy is 10 % by weight or less. The support in the invention is most preferably a pure aluminum support. However, it is difficult to prepare completely pure aluminum because of problems regarding a purifying process. Therefore, the aluminum plate may contain a trace amount of elements other than aluminum. As described above, the composition of the aluminum plate to be used in the invention is not particularly limited, and any of aluminum plates which are known and used in the art, for example, those satisfying requirements stipulated in JIS A1050, A1100, A3103, or A3 005, may be appropriately used.

The thickness of the aluminum support for use in the invention is about 0.1 mm to about 0.6 mm. The thickness may be suitably changed according to the size of printing machine, the dimension of printing plate, and needs by users. The surface of the aluminum support used in the invention may be subjected to treatment described hereinafter and be hydrophilized, if necessary.

### (Surface roughening treatment)

The surface of the aluminum support may be roughened. Examples of a method for roughening a surface include mechanical surface roughening, chemical etching, and electrolytic graining disclosed in JP-A No. 56-28893; an electrochemical surface roughening method of electrochemically roughening a surface in a hydrochloric acid or nitric acid electrolyte; and a mechanical surface roughening method such as a wire brush graining method of scratching an aluminum surface with a metal wire, a ball graining method of roughening an aluminum surface with a polishing ball and an abrasive, and a brush graining method of roughening a surface with a nylon brush and an abrasive. One of these roughening methods or a combination of two or more of them can be conducted. The surface roughening method is preferably an electrochemical method of chemically roughening a surface in a hydrochloric or nitric acid electrolyte. The suitable amount of electric current is in a range of 50 to 400 C/dm², when the support serves as an anode. More specifically, alternate and/or direct current electrolysis is preferably carried out in an electrolyte having a hydrochloric or nitric acid content of 0.1 to 50 % at a temperature in a range of 20 to 80°C at an electric current density of 100 to 400 C/dm² for one second to 30 minutes.

The aluminum support whose surface has been roughened may be chemically etched in an acid or alkaline solution. Typical examples of an etching agent include sodium hydroxide, sodium carbonate, sodium aluminate, sodium metasilicate, sodium phosphate, potassium hydroxide, and lithium hydroxide. The concentration and the temperature of the etching agent are 1 to 50 %, and 20 to 100°C, respectively. In order to remove stains which remains on the etched surface (smuts), the support is washed with acid. Typical examples of the acid used include nitric acid, sulfuric acid, phosphoric acid, chromic acid, hydrofluoric acid, and borofluoric acid. A method for removing smuts on a surface electrochemically roughened is preferably a method described in JP-A No. 53-12739 in which a surface is brought into contact with 15 to 65% by weight of sulfuric acid at a temperature in a range of 50 to 90°C, and a method described in JP-B 48-28123 in which a surface is etched with alkali. The method and conditions are not particularly limited, as long as the surface roughness of the roughened surface Ra is about 0.2 to 0.5 µm.

### (Anodizing treatment)

The aluminum support which has been treated above and has an oxide layer thereon is then anodized.

In the anodizing treatment, one or more aqueous solutions of sulfuric acid, phosphoric acid, oxalic acid, and boric acid/sodium borate are used as the main component of an electrolytic solution. The electrolyte solution may contain other components commonly found in aluminum alloy plates, electrodes, tap water, and underground water. The electrolyte solution may also contain a second component and may further contain a third component. Examples of the second and third components include cations including metal ions such as Na, K, Mg, Li, Ca, Ti, Al, V, Cr, Mn, Fe, Co, Ni, Cu, and Zn, and an ammonium ion; and anions such as nitrate, carbonate, chloride, phosphate, fluoride, sulfite, titanate, silicate, and borate ions. The concentration of the second and third components is preferably about 0 to 10,000 ppm. Although the conditions for the anodizing treatment are not particularly limited, the treatment is preferably performed by direct or alternating current electrolysis at a content of an acid commonly used as the main component of the electrolyte solution of 30 to 500 g/liter, at an electrolyte solution temperature of 10 to 70°C and at an electric current density in a range of 0.1 to 40 A/m². The thickness of the resultant anodic oxidation film is in a range of 0.5 to 1.5 µm, and preferably in a range of 0.5 to 1.0 µm. The conditions for the treatment are preferably selected such that the anodic oxidation film formed on the treated support has micropores having a size of 5 to 10 nm and a pore density of 8 x 10¹⁵ to 2 x 10¹⁶ pores/m².

A treatment for imparting hydrophilicity to the surface of the support can be any of well known methods. A treatment for imparting hydrophilicity with silicate or polyvinylphosphonic acid is particularly preferably conducted. The film is formed such that the amount of a silicon or phosphorus element is 2 to 40 mg/m², and preferably 4 to 30 mg/m². The coated amount may be measured by a fluorescent X-ray analysis method.

The treatment for imparting hydrophilicity is performed, for example, by immersing the aluminum support having thereon an anodic oxidation film in an aqueous solution containing 1 to 30% by weight, and preferably 2 to 15% by weight of alkali metal silicate or polyvinylphosphonic acid, having, at 25°C, a pH of 10 to 13 and kept at a temperature in a range of 15 to 80°C for 0.5 to 120 seconds.

The alkali metal silicate salt used for the hydrophilizing treatment can be sodium silicate, potassium silicate, and/or lithium silicate. Hydroxides are used to raise the pH of the solution of the alkali metal silicate salt, and examples thereof include sodium hydroxide, potassium hydroxide, and lithium hydroxide. An alkaline earth metal salt or a salt including a metal of Group IVB may be added to the treatment solution. Examples of the alkaline earth metal salt include water-soluble salts including nitrates such as calcium nitrate, strontium nitrate, magnesium nitrate, and barium nitrate, sulfates, hydrochlorides, phosphates, acetates, oxalates, and borates. Examples of the salt including a metal of Group IVB include titanium tetrachloride, titanium trichloride, titanium potassium fluoride, titanium potassium oxalate, titanium sulfate, titanium tetraidodide, zirconium oxychloride, zirconium dioxide, and zirconium tetrachloride.

One of the alkaline earth metal salts and the salts each including a metal of Group IVB may be used or two or more of them can be used together. The content of the metal salt is preferably 0.01 to 10% by weight, and more preferably 0.05 to 5.0% by weight. Moreover, silicate electrodeposition as described in U.S. Patent No. 3,658,662 is also effective. Surface treatment in which a support electrolytically grained as disclosed in JP-B No. 46-27481, JP-A Nos. 52-58602 or 52-30503, and the anodizing treatment and the treatment for imparting hydrophilicity described above are combined with each other is also useful.

### (Preparation of planographic printing plate precursor)

The planographic printing plate precursor of the invention has in the order of a photosensitive layer and a protective layer on a support and may have an undercoat layer, if necessary. The planographic printing plate precursor is prepared by dissolving the above-described components in a suitable solvent and applying the resulting coating liquid to a support sequentially.

The photosensitive layer is formed by dissolving the above-described components of a photosensitive layer in an organic solvent and applying the resultant photosensitive layer coating liquid to a support or an undercoat layer.

Examples of the solvent include acetone, methyl ethyl ketone, cyclohexane, ethyl acetate, ethylene dichloride, tetrahydrofuran, toluene, ethylene glycol monomethylether, ethylene glycol monoethylether, ethylene glycol dimethylether, propylene glycol monomethylether, propylene glycol monoethylether, acetylacetone, cyclohexanone, diacetone alcohol, ethylene glycol monomethylether acetate, ethylene glycol ethylether acetate, ethylene glycol monoisopropylether acetate, ethylene glycol monobutylether acetate, 3-methoxypropanol, methoxymethoxyethanol, diethylene glycol monomethylether, diethylene glycol monoethylether, diethylene glycol dimethylether, diethylene glycol diethylether, propylene glycol monomethylether acetate, propylene glycol monoethylether acetate, 3-methoxypropyl acetate, N,N-dimethylformamide, dimethylsulfoxide, γ-butylolactone, methyl lactate, and ethyl lactate. One of these solvents may be used or two or more of them can be used together. The concentration of solid matters in the coating liquid for photosensitive layer is prefeably 2 to 50 % by weight.

The coating amount of the photosensitive layer can mainly influence on the sensitivity and the developing property of the photosensitive layer, and the strength and the printing durability of an exposed layer, and therefore, is preferably selected according to applications of the precursors. When the coating amount is too small, printing durability becomes insufficient. On the contrary, when it is too large, sensitivity decreases, and consequently exposure of such a precursor requires much time, and development of the exposed plate needs longer time, and therefore, it is not desirable. For the planographic printing plate precursor for scanning and exposure, the coating amount of the photosensitive layer is preferably in a range of about 0.1 to about 10 g/m², and more preferably in a range of 0.5 to 5 g/m² based on the dry weight.

### (Intermediate Layer (Undercoat layer))

The planographic printing plate precursor of the invention may have an intermediate layer (also referred to as an undercoat layer) for the purpose of improving adhesiveness between the photosensitive layer and the support and the staining property of the precursor. Specific examples of such an intermediate layer include those described in JP-B No. 50-7481, JP-A Nos. 54-72104, 59-101651, 60-149491, 60-232998, 3-56177, 4-282637, 5-16558, 5-246171, 7-159983, 7-314937, 8-202025, 8-320551, 9-34104, 9-236911, 9-269593, 10-69092, 10-115931, 10-161317, 10-260536, 10-282682, 11-84674, 11-38635, 11-38629, 10-282645, 10-301262, 11-24277, 11-109641, 10-319600, 11-84674, 11-327152, 2000-10292, 2000-235254, 2000-352854, and 2001-209170, and Japanese Patent Application No. 11-284091.

### (Plate-making method)

Hereinafter, the method of making the planographic printing plate according to the invention will be described in detail.

The planographic printing plate precursor according to the invention described above is produced characteristically in the steps of placing a laminate of planographic printing plate precursors prepared by laminating multiple layers of a protective layer and an aluminum plate with each of the protective layers in contact with the rear surface of an aluminum support in a plate setter, conveying each of the planographic printing plate precursors automatically, exposing the precursor with a light having a wavelength of 750 to 1,400 nm, and developing the precursor practically without conducting heat treatment under the condition of a conveyance speed of 1.25 m/min or more.

The planographic printing plate precursor according to the invention described above can be applied to the plate-making method described above, because adhesiveness between planographic printing plate precursors and generation of scratch on the protective layer are controlled even when they are layered without inserting a laminated paper between the precursors.

The method of making the planographic printing plate according to the invention, which uses a laminate of planographic printing plate precursors without a laminated paper, eliminates the need for removal of the laminated paper and improves the productivity in the plate-making process.

The plate-making method is not only favorable for the planographic printing plate precursor according to the invention, but may also be applied favorably for the planographic printing plate precursor having a polymerizable negative type photosensitive layer that at least contains an infrared absorbent, a polymerization initiator, and a polymerizable compound and becomes less soluble in alkaline developing solution by exposure to a light at a wavelength of 750 to 1,400 nm. Specifically, the latter precursor has a photosensitive layer containing respective components, the "infrared absorbent, polymerization initiator, and polymerizable compound" described above as the components for the photosensitive layer of the planographic printing plate precursor according to the invention, and the layer may or may not contain a known binder polymer.

In addition, the photosensitive layer to which the method of making the planographic printing plate according to the invention is applied preferably has physical properties of a developing speed of 80 nm/sec or more in an alkaline developing solution at pH 10 to 13.5 in the unexposed area and a permeation speed of the alkaline developing solution into the exposed area at 50 nF/sec or less. The methods described in an application, JP-A No. 2004-248535, filed by the applicant may be used for determining the developing speed of the photosensitive layer in the unexposed area and the permeation speed of the alkaline developing solution into the photosensitive layer after hardening. Any one of common methods may be used for controlling the developing speed of the photosensitive layer in the unexposed area or the permeation speed of the alkaline developing solution into the photosensitive layer after hardening, and typically, a methods of using the specific binder polymer described above is useful; addition of a hydrophilic compound is useful for improvement of the developing speed in the unexposed area, while addition of a hydrophobic compound is useful for control of penetration of the developing solution into the exposed area.

### (Exposure)

The light source for use in the exposure of the invention is not particularly limited if it emits a light at a wavelength of 750 nm to 1,400 nm, but an infrared laser is preferable. Among infrared lasers, a solid-state or semiconductor laser emitting an infrared light at a wavelength of 750 nm to 1,400 nm is preferable for image exposure in the invention. The laser output is preferably 100 mW or more, and use of a multi-beam laser device is preferable for shortening the exposure period. The exposure period per pixel is preferably 20µ seconds or less. The energy of the light irradiated onto the planographic printing plate precursor is preferably 10 to 300 mJ/cm². An excessively low light-exposure energy prohibits sufficient hardening of the photosensitive layer. Alternatively, an excessively high light-exposure energy may result in laser ablation of the photosensitive layer and thus in damage of the image.

In the invention, the exposure is executed such that light beams from a light source overlap. The phrase "light beams from a light source overlap" means that the pitch of sub-scanning is smaller than the diameter of each light beam. When the beam diameter is expressed by the half breadth of the beam intensity (FWHM), the degree of overlap can be quantitatively expressed by FWHM/sub-scanning pitch (overlap coefficient). In the invention, the overlap coefficient is preferably 0.1 or higher.

The scanning method of the light source in the exposure device for use in the invention is not particularly limited, and the exposure may be performed either by scanning the external or internal wall of cylindrical printing plate precursor or the surface of flat printing plate precursor. The channel of the light source may be single channeled or multi channeled, but the multi-channeled light source is favorably used in the mode of scanning the external surface of cylindrical precursor.

In the invention, as described above, the planographic printing plate precursor is supplied after exposure to the development step without conducting particular heat treatment or washing treatment. Absence of the heat treatment allows suppression of the unevenness of images caused by the heat treatment. In addition, absence of the heating and washing treatments enables steady development at high speed.

### (Development)

The non-image region in the photosensitive layer is removed by using a developing solution during development in the invention. In the invention, as described above, the processing speed during development, i.e., the conveyance speed (line speed) of the planographic printing plate precursor during development, should be 1.25 m/min or more and more preferably 1.35 m/min or more. The upper limit of the conveyance speed is not particularly limited, but preferably 3 m/min or less from the viewpoint of stability.

Hereinafter, the developing solution for use in the invention will be described below.

### (Developing solution)

The developing solution for use in the invention is preferably an aqueous alkaline solution at pH 14 or lower and preferably contains an aromatic anionic surfactant.

### (Aromatic anionic surfactant)

In the invention, the aromatic anionic surfactant for use in the developing solution is effective in accelerating development and dispersing and stabilizing the components for the polymerizable negative photosensitive layer and the protective layer in the developing solution and is thus favorable for stabilization of development. In particular, the aromatic anionic surfactant for use in the invention is preferably a compound represented by the following Formula (A) or (B):

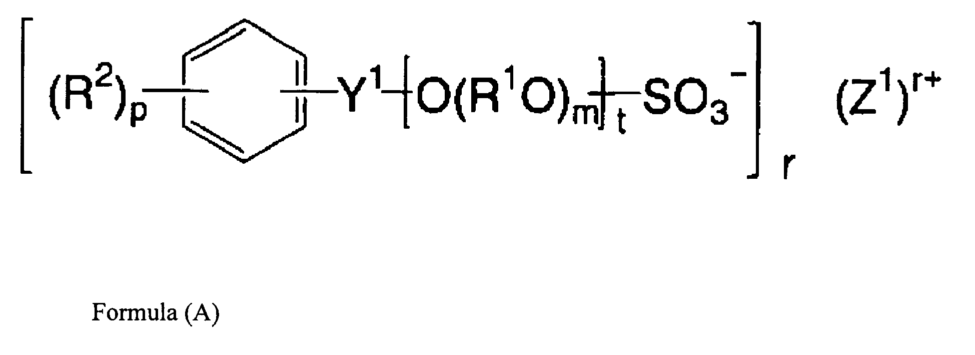

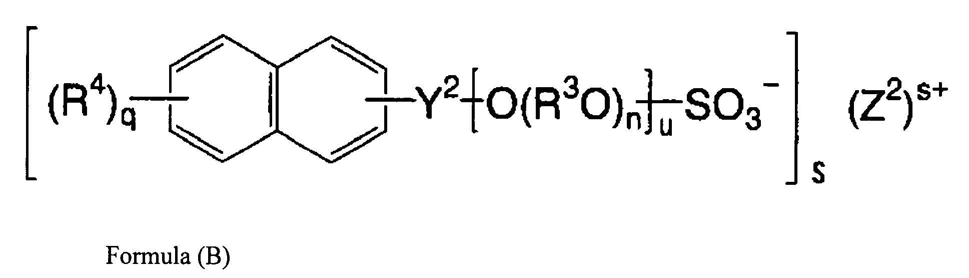

In formula (A) or (B), R¹ and R³ each represent a linear or branched alkylene group having 1 to 5 carbon atoms, and specific examples thereof include an ethylene group, a propylene group, a butylene group, and a pentylene group. Each of R¹ and R³ is particularly preferably an ethylene group or a propylene group.

m and n each are an integer of 1 to 100, and are preferably an integer of 1 to 30, and more preferably an integer of 2 to 20. When m is 2 or more, multiple R¹ groups may be the same as or different from each other. Similarly, when n is 2 or more, multiple R³ groups may be the same as or different from each other.

t and u each are 0 or 1.

R² and R⁴ each represent a linear or branched alkyl group having 1 to 20 carbon atoms, and specific examples thereof include a methyl group, an ethyl group, a propyl group, a butyl group, a hexyl group, and a dodecyl group. Each of R² and R⁴ is particularly preferably a methyl group, an ethyl group, an iso-propyl group, a n-propyl group, a n-butyl group, an iso-butyl group, or a tert-butyl group.

p and q each represent an integer of 0 to 2. Y¹ and Y² each represent a single bond or an alkylene group having 1 to 10 carbon atoms. Each of Y¹ and Y² is preferably a single bond, a methylene group, or an ethylene group, and more preferably a single bond.

(Z¹)^{r+} and (Z²)^{s+} each represent an alkali metal ion, an alkaline earth metal ion, or a unsubstituted or alkyl-substituted ammonium ion, and specific examples thereof include a lithium ion, a sodium ion, a potassium ion, a magnesium ion, a calcium ion, an ammonium ion, secondary to quaternary ammonium ions substituted with an alkyl group having 1 to 20 carbon atoms, an aryl group, and/or an aralkyl group. Each of (Z¹)^{r+} and (Z²)^{S+} is particularly preferably a sodium ion. r and s each represent 1 or 2.

Specific examples of the compound are shown below, but the invention is not limited thereto.

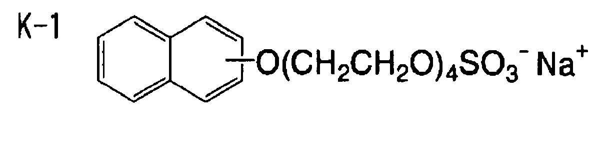

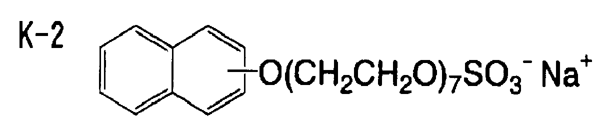

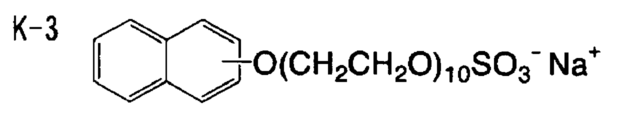

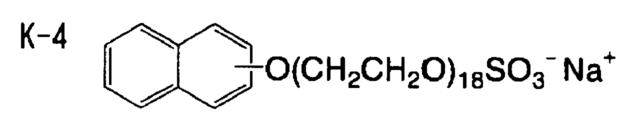

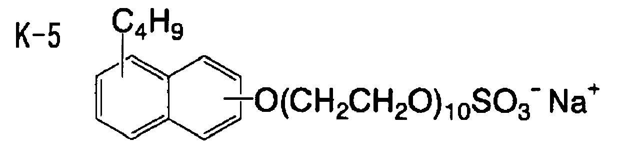

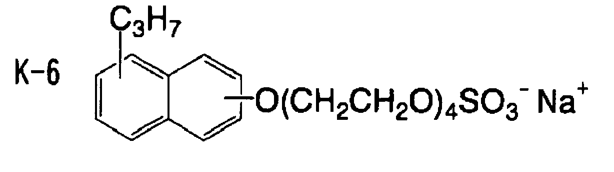

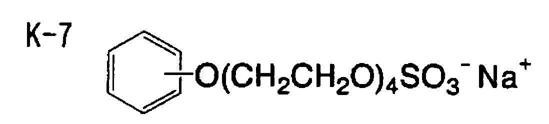

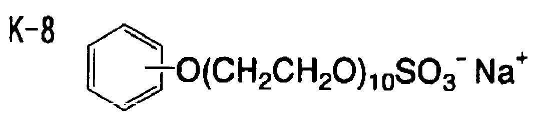

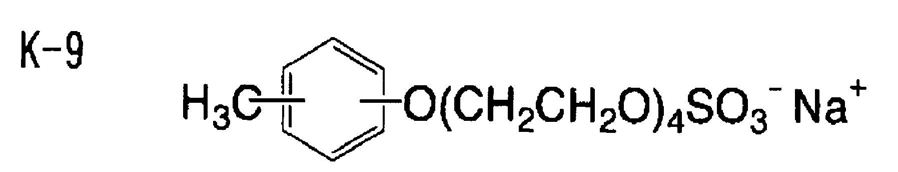

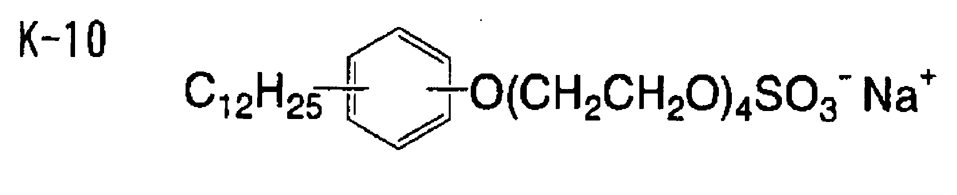

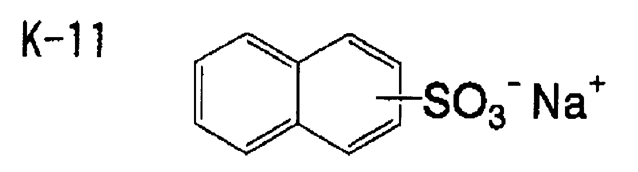

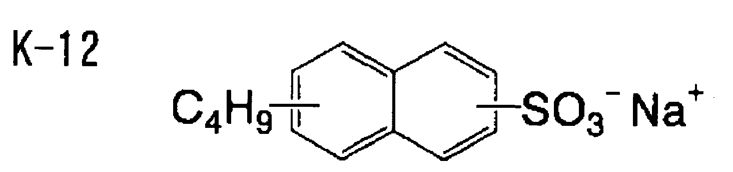

One of these aromatic anionic surfactants may be used or two or more of them can be used together. The concentration of the aromatic anionic surfactant in the developing solution is preferably in a range of 1.0 to 10 % by weight and more preferably in a range of 2 to 10 % by weight. When the concentration is less than 1.0 % by weight, the developing property and the solubility of the photosensitive layer components deteriorate. When the concentration is more than 10 % by weight, the printing durability of a printing plate deteriorates.

The developing solution used in the invention may also contain other surfactants in addition to the aromatic anionic surfactant. Examples of other surfactants include nonionic surfactants including polyoxyethylene alkyl ethers such as polyoxyethylene naphthyl ether, polyoxyethylene alkyl phenyl ethers, polyoxyethylene lauryl ether, polyoxyethylene cetyl ether, and polyoxyethylene stearyl ether; polyoxyethylene alkyl esters such as polyoxyethylene stearate; sorbitan alkyl esters such as sorbitan monolaurate, sorbitan monostearate, sorbitan distearate, sorbitan monooleate, sorbitan sesquioleate, and sorbitan trioleate; and monoglyceride alkyl esters such as glycerol monostearate and glycerol monooleate.

The content of other surfactant(s) in the developing solution is preferably 0.1 to 10 % by mass when calculated on the basis of active components.

### (Chelating agent for bivalent metal)

The developing solution used in the invention preferably contains a chelating agent for bivalent metal(s), for example, to suppress the adverse effects of the bivalent metals such as an calcium ion contained in hard water. Examples of the chelating agent for bivalent metal(s) include polyphosphates such as Na₂P₂O₇, Na₅P₃O₃, Na₃P₃O₉, Na₂O₄P(NaO₃P)PO₃N and Calgon (sodium polymetaphosphate); amino-polycarboxylic acids such as ethylenediamine tetraacetic acid and potassium, sodium, and amine salts thereof, diethylenetriamine pentaacetic acid and potassium and sodium salts thereof, triethylenetetramine hexaacetic acid and potassium and sodium salts thereof, hydroxyethylethylenediamine triacetic acid and potassium and sodium salts thereof, nitrilotriacetic acid and potassium and sodium salts thereof, 1,2-diaminocyclohexane tetraacetic acid and potassium and sodium salts thereof, and 1,3-diamino-2-propanol tetraacetic acid and potassium and sodium salts thereof; and organic phosphonic acids such as 2-phosphonobutane tricarboxylic acid-1,2,4 and potassium and sodium salts thereof; 2-phosphonobutanone tricarboxylic acid-2,3,4 and potassium and sodium salts thereof; 1-phosphonoethane tricarboxylic acid-1,2,2 and potassium and sodium salts thereof; 1-hydroxyethane-1,1-diphosphonic acid and potassium and sodium salts thereof, and aminotri(methylenephosphonic acid) and potassium and sodium salts thereof. The chelating agent for bivalent metal(s) is preferably ethylenediamine tetraacetic acid or a potassium, sodium, or amine salt thereof, ethylenediamine tetra(methylenephosphonic acid) or a ammonium or potassium salt thereof, or hexamethylenediamine tetra(methylenephosphonic acid) or a ammonium or potassium salt thereof.

The optimum content of the chelating agent depends on the hardness and the amount of hard water used. However, the content in the developing solution is generally in a range of 0.01 to 5 % by weight and preferably 0.01 to 0.5 % by weight.

The developing solution used in the invention may contain an alkali metal salt of an organic acid and/or an alkali metal salt of an inorganic acid as a development adjusting agent. For example, one salt or two or more of salts selected from sodium carbonate, potassium carbonate, ammonium carbonate, sodium citrate, potassium citrate, and ammonium citrate may be contained in the developing solution.

### (Alkali agent)

Examples of the alkali agent contained in the developing solution used in the invention include inorganic alkali agents such as odium tertiary phosphate, potassium tertiary phosphate, ammonium tertiary phosphate, sodium borate, potassium borate, ammonium borate, sodium hydroxide, potassium hydroxide, ammonium hydroxide, and lithium hydroxide; and organic alkali agents such as monomethylamine, dimethylamine, trimethylamine, monoethylamine, diethylamine, triethylamine, monoisopropylamine, diisopropylamine, triisopropylamine, n-butylamine, monoethanolamine, diethanolamine, triethanolamine, monoisopropanolamine, diisopropanolamine, ethyleneimine, ethylenediamine, pyridine, and tetramethylammonium hydroxide. In the invention, one of these alkali agents may be used or two or more of them can be used together.

In addition, an alkali silicate may be included in the alkali agent. The alkali silicate may be used in combination with a base. The alkali silicate salt used is a salt that becomes alkaline when dissolved in water, and examples thereof include sodium silicate, potassium silicate, lithium silicate, and ammonium silicate. One of these alkali silicates may be used or two or more of them can be used together.

The developing solution for use in the invention can be optimally adjusted by controlling the mixing ratio and the concentrations of silicon oxide SiO₂, that is a component of the silicate salt used as a hydrophilizing component for a support, and an alkali oxide M₂O (M represents an alkali metal or an ammonium group) used as an alkali component. The mixing ratio (molar ratio) of silicon oxide SiO₂ to alkali oxide M₂O (SiO₂/M₂O) is preferably in a range of 0.75 to 4.0, and more preferably in a range of 0.75 to 3.5 for the purpose of suppressing stains caused by leaving a support for too long period of time in the developing solution and by excessively dissolving (etching) the anodic oxide film on the support in the solution, or suppressing the generation of insoluble deposits caused by forming a complex of the dissolved aluminum and silicate.

From the viewpoints of suppression of the dissolution (etching) of the anodic oxide film disposed on the support, a developing property, suppression of precipitation and crystal growth, and suppression of the gelling of the alkali silicate caused by neutralization of wastewater, the concentration of the alkali silicate in the developing solution is such that the content of silicon dioxide in the developing solution is preferably in a range of 0.01 to 1 mol/L and more preferably in a range of 0.05 to 0.8 mol/L.

The developing solution used in the invention may further contain the following components in addition to the components described above, if necessary. Examples thereof include organic carboxylic acids such as benzoic acid, phthalic acid, p-ethylbenzoic acid, p-n-propylbenzoic acid, p-iso-propylbenzoic acid, p-n-butylbenzoic acid, p-t-butylbenzoic acid, p-2-hydroxyethylbenzoic acid, decanoic acid, salicyclic acid, and 3-hydroxy-2-naphthoic acid; organic solvents such as propylene glycol; and reducing agents, dyes, pigments, water softeners, and antiseptics.

The pH of the developing solution for use in the invention is preferably in a range of 10 to 12.5 and more preferably in a range of 11 to 12.5 at 25°C. Even when the developing solution used in the invention has such a low pH, the developing solution contains the surfactant described above, and therefore exhibits an excellent developing property with respect to the non-image portion of a plate. Adjusting the pH of the developing solution to a relatively low value can lessen damage on image portions during development and facilitate handling of the developing solution.

The electric conductivity x of the developing solution is preferably 2 to 30 mS/cm and more preferably 5 to 25 mS/cm.

It is preferable to add an alkali metal salt of an organic or inorganic acid to the developing solution as an agent for adjusting the electric conductivity of the developing solution.

The developing solution can be reused as a developing solution or a replenishing development solution for the exposed planographic printing plate precursor, and is preferably applied to automatic developing machines. When the precursor is developed in an automatic developing machine, the developing solution becomes deteriorated as the processing amount increases, and the processing efficiency may be recovered by adding a replenishing solution or a fresh developing solution. The replenishing system is favorably used also in the plate-making method according to the invention.

Use of the replenishing method described in U.S. Patent No. 4,882,246 is also preferable for recovering the processing efficiency of the developing solution in automatic developing machine. The developing solutions described in JP-A Nos. 50-26601 and 8-54341 and JP-B Nos. 56-39464, 56-42860, and 57-7427 are also preferable.

The planographic printing plate precursor thus developed is then post-treated with a washing solution containing, for example, washing water, a surfactant, and others, and with a desensitizing solution containing gum Arabic, starch derivative, or the like, as described in JP-A Nos. 54-8002, 55-115045, and 59-58431, and others. These treatments are used in combination with post-treatment of the planographic printing plate precursor according to the invention. The planographic printing plate after such treatments is then supplied to an offset printing machine, in which it is used for printing on a number of sheets of papers.

In the method of making the planographic printing plate according to the invention, the entire surface of the image after development may be post-heated or exposed to light for the purpose of improving the image intensity and printing durability.

A very severe conditions may be used during the heating after development. It is normally performed at a heating temperature in the range of 200 to 500°C. A lower heating temperature after development may lead to deterioration in image intensity, while an excessively higher temperature may lead to the problems of degradation of the support and thermal decomposition of the image region.

Subsequently, the planographic printing plate(s) obtained from the above procedure is (are) set in an offset printing machine and used to print images on a number of sheets of paper.

A plate cleaner is used to remove stains on the plate during printing, and is a conventionally known plate cleaner for PS plates. Examples thereof include CL-1, CL-2, CP, CN-4, CN, CG-1, PC-1, SR, and IC (manufactured by Fuji Photo Film Co. Ltd.).

Hereinafter, the present invention will be described with reference to examples, but is not limited thereto.

### EXAMPLES

### (Example 1)

### (Preparation of support)

A JIS-A1050 aluminum plate having a thickness of 0.30 mm and a width of 1,030 mm was surface treated as follows:

### Surface treatment

The surface treatment was carried out by sequentially conducting the following steps (a) to (f). After each step and water washing, liquid remaining on the aluminum plate was removed with a nip roller.
(a) The aluminum plate was etched in a solution containing 26 weight % of sodium hydroxide and 6.5weight % of aluminum ions at 70°C, until the amount of dissolved aluminum became 5 g/m². The etched plate was then washed with water.
(b) The aluminum plate was desmutted by spraying an aqueous solution including 1 weight % of nitric acid and 0.5weight % of aluminum ions and kept at 30°C to the plate. The aluminum plate was then washed with water.
(c) The surface of the aluminum plate was continuously electrochemically roughened by applying an alternate current voltage having a frequency of 60 Hz to the plate immersed in an electrolyte which was an aqueous solution including 1 weight % of nitric acid, 0.5 weight % of aluminum ions and 0.007 weight % of ammonium ions and kept at 30°C. The alternate current voltage had a trapezoidal waveform, a time (TP) which it took to increase an electric current value from zero to peak was 2 mseconds, and a duty ratio was 1:1. In the treatment, a carbon electrode was used as a counter electrode. A ferrite electrode was used as an auxiliary anode. The electric current density was 25 A/dm² at the peak of electric current. The total amount of electricity used in this treatment and used when the aluminum plate served as an anode was 250 C/cm². A part (5%) of the current supplied from a power source was applied to the auxiliary anode. The aluminum plate was then washed with water.
(d) The aluminum plate was etched by spraying a solution containing 26 weight % of sodium hydroxide and 6.5 weight % of aluminum ions to the plate at 35°C, until the amount of dissolved aluminum became 0.2 g/m². Thereby, smuts mainly containing aluminum hydroxide which had occurred during the electrochemical surface roughening by using the alternate current were removed, and the edge portions of pits generated were dissolved and smoothened. The aluminum plate was then washed with water.
(e) The aluminum plate was desmutted by spraying an aqueous solution containing 25 weight % of sulfuric acid and 0.5 weight % of aluminum ions and kept at 60°C to the plate. Water was sprayed on the plate to wash the plate.
(f) The aluminum plate was anodized in an electrolyte containing sulfuric acid at a concentration 170 g/L and additionally containing aluminum ions at a concentration 0.5 weight % and kept at 33°C at an electric current density of 5 A/dm² for 50 seconds. The aluminum plate was then washed with water. After the treatment, the amount of anodic oxide film was 2.7 g/m². An aluminum support was thus obtained. The surface roughness Ra of the aluminum support was measured with an apparatus, SURFCOM manufactured by Tokyo Seimitsu Co. Ltd., having a stylus with a distal diameter of 2 µm, and found to be 0.27.

Subsequently, the following undercoat layer coating liquid was applied to the aluminum support with a wire bar and the resultant coating was dried at 90°C for 30 seconds. The coating amount was 10 mg/m².

### Undercoat layer coating liquid

- Polymer compound A having the following structure 0.05 g
- Methanol 27 g
- Ion exchanged water 3 g

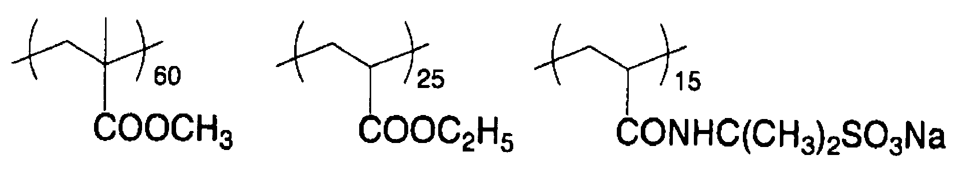

### Polymer compounds A

### (Photosensitive layer)

Subsequently, the following photosensitive layer coating liquid [P-1] was prepared and applied to the aluminum support with a wire bar, and the resultant coating on the aluminum support was dried for 34 seconds at 115°C in a hot air dryer. Thus, a planographic printing plate precursor was obtained. The dry coating amount of the photosensitive layer was 1.3 g/m².

### <Photosensitive layer coating liquid [P-1]>

- Infrared ray absorbent (IR-1) 0.074 g
- Polymerization initiator (OS-12) 0.280 g
- Additive (PM-1) 0.151 g
- Polymerizable compound (AM-1) 1.00 g
- Specific binder polymer (BT-1) 1.00 g
- Ethyl violet (C-1) 0.04 g
- Fluorinated surfactant 0.015 g
   (MEGAFAC F-780-F manufactured by Dainippon Ink and Chemicals, Inc., 30 wt % solution including isobutyl ketone)
- Methyl ethyl ketone 10.4 g
- Methanol 4.83 g
- 1-Methoxy-2-propanol 1 0.4 g

The polymerization initiator (OS-12) used for the above photosensitive layer coating liquid is the same compound mentioned as an example of the onium salt compound represented by Formula (1).

The structures of the infrared ray absorbent (IR-1), additive (PM-1), polymerizable compound (AM-1), binder polymer (BT-1), and ethyl violet (C-1) used in the photosensitive layer coating liquid are shown below.

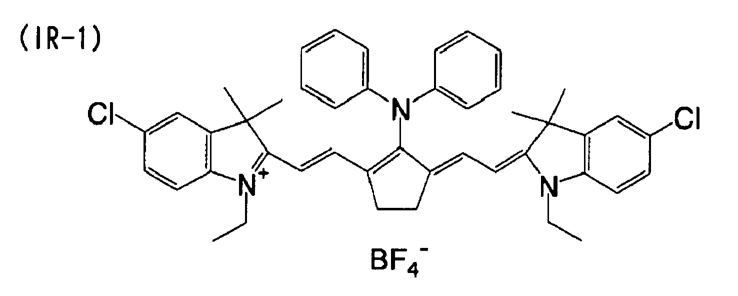

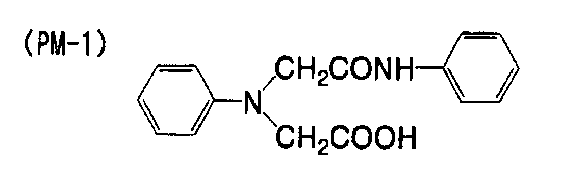

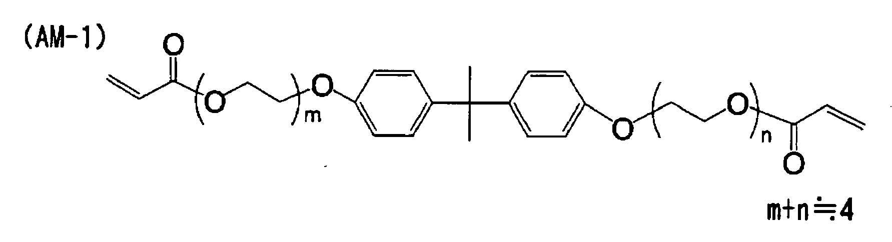

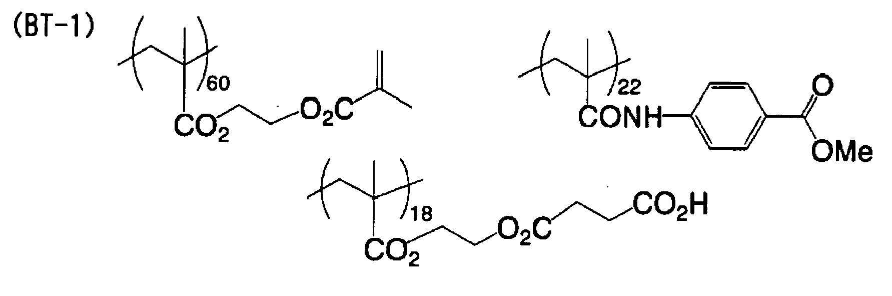

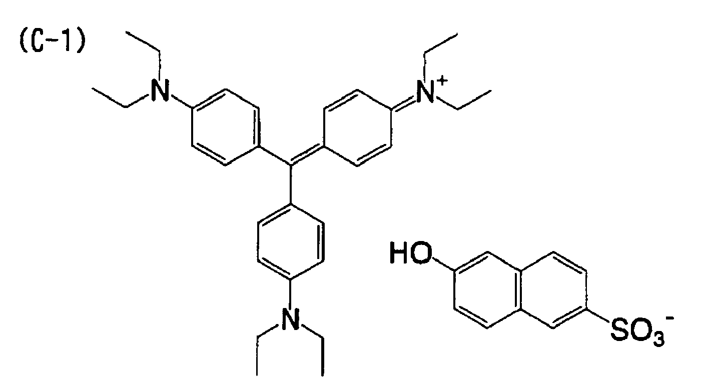

### (Protective layer)

An aqueous mixture solution (coating solution for protective layer) containing a synthetic mica (Somasif ME-100, 8% aqueous dispersion, manufactured by CO-OP Chemical Co., Ltd.), a specific polyvinylalcohol having a saponification value of 91 mole % or more (JM-05, manufactured by Japan VAM & POVAL Co., Ltd., saponification value: 94 mole %, polymerization degree: 500), a copolymer of polyvinylpyrrolidone and vinyl acetate (LUVITEC VA 64W,manufactured by ICP, polyvinylpyrrolidone/vinyl acetate= 6/4), and a surfactant (Emalex 710, manufactured by Nihon-Emulsion Co., Ltd.) was applied with a wire bar onto the surface of the photosensitive layer described above, and the resultant coating was dried in a hot air dryer at 125°C for 75 seconds.

The content ratio of solid mica/specific polyvinylalcohol/copolymer of polyvinylpyrrolidone and vinyl acetate/surfactant in the aqueous mixture solution (coating solution for protective layer) was 16/80/2/2 (mass %), and the total coating amount (weight of film after drying) was 0.62 g/m². In this manner, a planographic printing plate precursor of Example 1 was prepared.

### (Examples 2 to 7)

Each of the planographic printing plate precursors of Examples 2 to 7 was obtained in a similar manner to Example 1, except that the kind and content of the mica compound and the kind of the binder component (specific polyvinylalcohol) in the composition of the aqueous mixture solution (coating solution for protective layer) of Example 1 were changed to those shown in the following Table 1 and the total coating amount was also changed to that shown in the following Table 1. When the content of the mica compound is changed, the content of the specific polyvinylalcohol was also adjusted to compensate the change. In other words, the content ratio of the copolymer of polyvinylpyrrolidone and vinyl acetate and the surfactant was unchanged.

"Micro Mica MK-100" in Table 1 is a synthetic mica manufactured by CO-OP Chemical Co., Ltd.

### (Examples 8 to 11)

Planographic printing plate precursors of Examples 8 to 11 were prepared in a similar manner to Example 1, except that the binder component particular polyvinylalcohol in the mixed aqueous solution (coating solution for protective layer) of Example 1 was changed from JM-05 to the acid-modified polyvinylalcohol shown in the following Table 1, the composition was changed to a content ratio of mica solid matter /acid-modified polyvinylalcohol /copolymer of polyvinylpyrrolidone and vinyl acetate /surfactant of 10/86/2/2 (wt %), and the coating amount was changed to 1.0 g/m².

### (Example 12)

A planographic printing plate precursor of Example 12 was prepared in a similar manner to Example 8, except that the binder component specific polyvinylalcohol (acid-modified polyvinylalcohol) in the mixed aqueous solution (coating solution for protective layer) of Example 8 was change to the non-acid-modified particular polyvinylalcohol shown in the following Table 1.

### (Comparative Examples 1 and 2)

Planographic printing plate precursors of Comparative Examples 1 and 2 were obtained in a similar manner to Example 1, except that the specific polyvinylalcohol, a binder component of the aqueous mixture solution (coating solution for protective layer) of Example 1, was replaced with the polyvinylalcohol shown in the following Table 1 having a saponification value outside the range of the invention.

### (Comparative Example 3)

A planographic printing plate precursor of Comparative Example 3 was prepared in a similar manner to Example 1, except that the specific polyvinylalcohol, a the binder component of the aqueous mixture solution (coating solution for protective layer) of Example 1, was changed from JM-05 to KL-506 (having a saponification value of 77.0 mole %, manufactured by Kuraray Co., Ltd.), the composition ratio of mica solid matter/KL-506/copolymer of polyvinylpyrrolidone and vinyl acetate/surfactant was changed to 55/41/2/2 (wt %), and the coating amount was changed to 2.0 g/m².

### (Comparative Example 4)

A planographic printing plate precursor of Comparative Example 4 was prepared in a similar manner to Example 1, except that the specific polyvinylalcohol, a binder component of the aqueous mixture solution (coating solution for protective layer) of Example 1, was changed from JM-05 to PVA102 (having a saponification value of 98.5 mole %, manufactured by Kuraray Co., Ltd.), the composition ratio of mica solid matter /PVA102/copolymer of polyvinylpyrrolidone and vinyl acetate /surfactant was changed to 0/96/2/2(wt %), and the coating amount was changed to 2.0 g/m². The planographic printing plate precursor of Comparative Example 4 has a protective layer containing no mica compound.

### (Evaluation)

### (1) Evaluation of sensitivity

The planographic printing plate precursor obtained was exposed to light under the conditions of a resolution of 2,400 dpi, a peripheral drum rotational frequency of 150 rpm, and an increasing output in the range of 0 to 8 W at an interval of 0.15 as log E, by using Trend setter 3244 manufactured by Creo. The exposure was performed under the conditions of 25°C and 50% RH. After exposure, the planographic printing plate precursor was developed without heating and washing treatments in an automatic developing machine LP-1310HII manufactured by Fuji Photo Film Co., Ltd., at a conveyance speed (line speed) of 2 m/min and a developing temperature of 30°C. The developing solution had the composition below, and the finisher was a 1:1 water-diluted solution of GN-2K manufactured by Fuji Photo Film Co.

The density of the image portion developed on the planographic printing plate was determined by using Macbeth reflection densitometer RD-918, and the cyan concentration by using the red filter, an accessory of the densitometer. A reciprocal number of the exposure intensity needed for giving a measured density of 0.8 was determined as an indicator of the sensitivity. Evaluation results of the planographic printing plates are relative values, compared to 100 of the sensitivity of the planographic printing plate obtained in comparative example 1. A larger value indicates a higher sensitivity.

### (2) Evaluation of abrasion resistance

The planographic printing plate precursors obtained were layered without a laminated paper, to give a laminate. The laminated printing plate precursors were placed in a cassette and fed from the setting region by an auto-loader to the Trendsetter 3244 manufactured by Creo, and a 50% screen tint image was exposed to light under the conditions of a resolution of 2,400 dpi, an output of 7W, an external drum rotating frequency of 150 rpm, and a plate surface energy of 110 mJ/cm². After exposure, the precursor was developed in a similar manner to the sensitivity evaluation. Accordingly, a planographic printing plate was obtained, and presence of scratch generated in the screen tint image was evaluated visually. The evaluation results were grouped into five ranks visually, and rank 3 indicates a practical lower limit level, and rank 2 or less a practically unusable level.

### (3) Evaluation of adhesion between planographic printing plate precursors

Three planographic printing plate precursors obtained (10×10 cm) were conditioned for 2 hours in an environment at 25°C and 75% RH, and the three precursors were laminated in the same direction without using a laminated paper, to give a laminate. The laminated precursors were sealed with A1 Kraft paper tightly, and the package was left under a load of 4 kg at 30°C for 5 days. Then, the adhesion between the photosensitive layer-sided surface (protective layer surface) of a planographic printing plate precursor and the support-sided surface of the neighboring planographic printing plate precursor was evaluated. The results of the adhesion between planographic printing plate precursors as determined by visual evaluation were grouped into five ranks, and rank 3 indicates a practical lower limit level, and rank 2 or less a practically unusable level.

### (4) Evaluation of safelight endurance period

The planographic printing plate precursor obtained was exposed to light under a UV-cut fluorescent lamp at an illuminance of 400 Lx for a given period, and the period until there was fogging observed in the non-image region after development was determined. The criterion of generation of fogging is whether an exposed region had a reflective density higher by 0.2 or more that of the non-image region which was not exposed to safelight.

### (5) Evaluation of removability during development

Each of the planographic printing plate precursors obtained in Examples 8 to 12 was stored in an environment at 30°C and 75% RH for 10 days and then developed without image exposure, heat treatment, and water washing treatments in an automatic developing machine LP-1310HII manufactured by Fuji Photo Film Co., Ltd. at a traveling speed (line speed) of 2 m/minute and a developing temperature of 30°C. The developing solution used was a 1:4 water-diluted solution of DH-N, and the finisher used was a 1:1 water-diluted solution of GN-2K manufactured by Fuji Photo Film Co., Ltd.

The density in the non-image region of the planographic printing plate obtained after development was determined by using Macbeth reflection densitometer RD-918, and the cyan density was determined by using the red filter, an accessory of the densitometer. The removability during development was evaluated as a relative value, by comparing with the density of the supporting plate (which was regarded as 0) after surface-hydrophilizing treatment and before coating of protective, photosensitive, and undercoat layers. The value represents a density of the photosensitive layer remaining unremoved after development. The results are also shown in Table 1.

**[Table 1]**

| | Protective layer | | | | | | | Evaluation results | | | | |
|---|---|---|---|---|---|---|---|---|---|---|---|---|
| | Mica compound | | Polyvinylalcohol | | | Coating amount (g/m²) | Oxygen permeability (ml/m² xday) | sensitivity | Scrach resistance of protective layer | Adhesion resistance | UV-cut lamp endurance period (min) | density in non-image region |
| | Kind | Content(weight %) | Product name | Saponification value(mol%) | Average degree of polymerization | | | | | | | |
| Example 1 | Somasif ME-100 | 25 | JM-05 | 94 | 500 | 1.5 | 1.1 | 100 | 5 | 5 | 100 | |
| Example 2 | Somasif ME-100 | 5 | JM-05 | 94 | 500 | 2 | 1.2 | 100 | 5 | 4 | 100 | |
| Example 3 | Somasif ME-100 | 5 | JM-05 | 94 | 500 | 0.62 | 2.4 | 100 | 4 | 4 | 100 or more | |
| Example 4 | Somasif ME-100 | 16 | PVA-102 | 98.5 | 200 | 1.5 | 0.8 | 100 | 5 | 5 | 100 | |
| Example 5 | Somasif ME-100 | 20 | PVA-706 | 91.5 | 600 | 1.5 | 1.2 | 100 | 4 | 5 | 100 | |
| Example 6 | Micromica MK-100 | 10 | KM-118 | 98 | 1800 | 1 | 1 | 100 | 5 | 5 | 100 | |
| Example 7 | Somasif ME-100 | 10 | AL-06 | 93 | 600 | 1 | 3.1 | 100 | 5 | 5 | 100 | - |
| Example 8 | Somasif ME-100 | 10 | CKS-50 | 99 | 300 | 1 | 3.1 | 100 | 4 | 4 | 100 | 0.02 |
| Example 9 | Somasif ME-100 | 10 | KM-106 | 98.5 | 600 | 1 | 1.8 | 100 | 5 | 5 | 100 | 0.02 |
| Example 10 | Somasif ME-100 | 10 | GohsenolT-HS-1 | 99 | 1300 | 1 | 1.1 | 100 | 5 | 5 | 100 | 0.07 |
| Example 11 | Micromica MK-100 | 10 | GohsenolT-330H | 99 | 1700 | 1 | 2.1 | 100 | 5 | 5 | 100 | 0.08 |
| Example 12 | Somasif ME-100 | 10 | PVA 105 | 98.5 | 500 | 1 | 1.5 | 100 | 5 | 5 | 100 | 0.15 |
| Comparative Example 1 | Somasif ME-100 | 16 | PVA-203 | 88 | 300 | 1.5 | 5.2 | 100 | 2 | 5 | 100 | - |
| Comparative Example 2 | Somasif ME-100 | 25 | KL-506 | 77 | 600 | 1.5 | 4.8 | 100 | 1 | 5 | 100 | - |
| Comparative Example 3 | Somasif ME-100 | 55 | KL-506 | 77 | 600 | 2 | 0.4 | 80 | 2 | 5 | 80 | - |
| Comparative Example 4 | None | - | PVA-102 | 98.5 | 200 | 2 | 0.3 | 100 | 5 | 1 | 50 | - |

JM-05; manufactured by Japan VAM & POVAL Co., Ltd.

PVA-102, PVA-706, KM-118, PVA-203, and KL-506, KM-106, PVA-105; manufactured by Kuraray Co. Ltd.

AL-06, CKS-50, Gohsenol T-HS-1, Gohsenol T-330H: manufactured by Nippon Synthetic Chemical Industry Co., Lt

As apparent from Table 1, each of the planographic printing plate precursors obtained in Examples 1 to 12, i.e., planographic printing plate precursors prepared by forming a protective layer containing a mica compound and a specific polyvinylalcohol on a polymerizable negative light-sensitive layer, was highly sensitive and superior in abrasion resistance even without inserting a laminated paper; and the planographic printing plates did not adhere to each other even after left under high humidity condition. Each of the planographic printing plate precursors obtained in Examples 1 to 12 had oxygen permeability in the favorable range and was superior in safelight endurance. In addition, the planographic printing plate precursors obtained in Examples 8 and 9, which contain an acid-modified polyvinylalcohol having an average degree of polymerization of 100 to 800 as the specific polyvinylalcohol, had a lower density of the nonimage portion even after storage under the conditions of 30°C and 75% RH for 10 days and did not show decrease in the removability during development by light irradiation.

In contrast, the planographic printing plate precursors of Comparative Examples 1 and 2 having a protective layer containing a mica compound and polyvinylalcohol in amounts respectively outside the favorable ranges of the invention were found to be highly sensitive and free from the adhesion between planographic printing plate precursors even after left in an high-humidity environment, but significantly lower in abrasion resistance. In addition, the planographic printing plate precursor of Comparative Example 3 having a protective layer containing the mica compound in an amount greater than the favorable range of the invention was superior in the adhesion resistance between planographic printing plate precursors after left in a high-humidity environment but lower in sensitivity and in safelight endurance because of its excessively lower oxygen permeability. On the other hand, the planographic printing plate precursor of Comparative Example 4 having a protective layer containing no mica compound was superior in sensitivity and abrasion resistance, but the planographic printing plate precursors were adhered to each other after left in a high-humidity environment, causing a practical problem. Further, the planographic printing plate precursor of Comparative Example 4 had extremely low oxygen permeability and was inferior in safelight endurance.

The operation of the invention is still not clear, but seems to be as follows:

The protective layer in the invention, which contains a mica compound and the particular polyvinylalcohol above, has improved film strength and a matted surface. For that reason, the protective layer prevents polymerization inhibition in the photosensitive layer, suppresses adhesion between the protective layer on the photosensitive layer-sided surface of a planographic printing plate precursor and support-sided surface of the neighboring planographic printing plate precursor when the planographic printing plate precursors having a protective layer are laminated, and suppresses the abrasion scratch generated between the surface of the protective layer and the rear surface of the aluminum support.

In addition, the protective layer in the invention preferably has a function of retaining its favorable removability of the photosensitive layer during development, for the purpose of preventing insufficient development of the photosensitive layer and suppressing printing stains. The insufficient development and the printing stains on the photosensitive layer are caused, for example, by excessive curing of the photosensitive layer and deterioration in the removability during development associated with the progress of dark-polymerization by heat during long-term storage of the planographic printing plate precursor. When a photosensitive planographic printing plate precursor is handled under indoor illumination, an increase in fogging by unintended exposure to the indoor illumination light lower in illuminance than laser exposure for an extended period of time (hereinafter, referred to as "safe-light fogging"), occasionally resulting in insufficient development of the photosensitive layer and generation of printing stains, was observed.

In an embodiment of the invention, it is preferable to use an acid-modified polyvinylalcohol having an average degree of polymerization of the vinylalcohol unit at 100 to 800 as the specific polyvinylalcohol contained in the protective layer, for prevention of the deterioration in the removability of photosensitive layer during development.

The invention provides a planographic printing plate precursor allowing printing with infrared laser and having a protective layer that improves the efficiency of plate-making and a plate-making method thereof.

More specifically, it provides a planographic printing plate precursor having a protective layer that suppresses the polymerization inhibition of the photosensitive layer, is superior in removability during development, controls the abrasion between the protective layer surface of the planographic printing plate precursor and the support-sided surface of the neighboring planographic printing plate precursor even when the planographic printing plate precursors are layered, and thus, prevents the abrasion scratch generated between the protective layer surface and the aluminum support rear face, on a photosensitive layer allowing printing with infrared laser, and a plate-making method thereof.

## Claims

1. A planographic printing plate precursor, comprising a photosensitive layer containing an infrared absorbent, a polymerization initiator, a polymerizable compound, and a binder polymer, and a protective layer formed in this order on a hydrophilic aluminum support surface, wherein the protective layer contains polyvinyalcohol having a saponification value of 91 mole % or more and a mica compound in an amount of 5 wt % to 50 wt % relative to the total weight of the protective layer.

2. The planographic printing plate precursor according to claim 1, wherein the oxygen permeability of the protective layer at 25°C and -1 atm is 0.5 ml/m²-day to 100 ml/m²·day.

3. The planographic printing plate precursor according to claim 1, wherein the binder polymer is a binder polymer having a repeating unit represented by the following Formula (i): 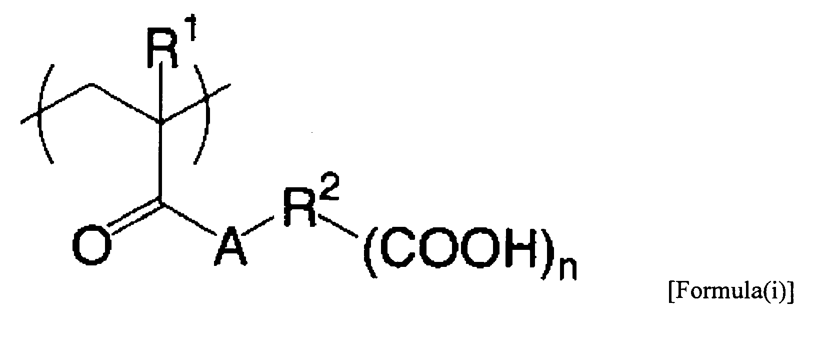 wherein R¹ represents a hydrogen atom or a methyl group, R² represents a connecting group which contains two or more atoms selected from the group consisting of a carbon atom, a hydrogen atom, an oxygen atom, a nitrogen atom, and a sulfur atom and which has 2 to 82 atoms in total, A represents an oxygen atom or -NR³-; R³ represents a hydrogen atom or a monovalent hydrocarbon group having 1 to 10 carbon atoms; and n represents an integer of 1 to 5.

4. The planographic printing plate precursor according to claim 1, wherein the polyvinylalcohol is a polyvinylalcohol having an average degree of polymerization in the range of 300 to 2,400.

5. The planographic printing plate precursor according to claim 1, wherein the polyvinylalcohol having a saponification value of 91 mol % or more is an acid-modified polyvinylalcohol having an average degree of polymerization of the vinylalcohol unit at 100 to 800.

6. The planographic printing plate precursor according to claim 1, wherein the polyvinylalcohol is used in combination with a binder component selected from the group consisting of polyvinylpyrrolidone, acidic celluloses, gelatin, Arabic gum, polyacrylic acid, and the copolymers thereof.

7. The planographic printing plate precursor according to claim 1, wherein the mica compound is a mica selected from the group consisting of the natural and synthetic micas represented by Formula: A(B,C)₂-5D₄O₁₀(OH,F,O)₂ wherein A represents K, Na, or Ca; each of B and C represents Fe(II), Fe(III), Mn, Al, Mg, or V; and D represents Si or Al.

8. The planographic printing plate precursor according to claim 7, wherein the mica compound is a synthetic mica selected from the group consisting of non-swelling micas such as fluorine phlogopite KMg₃(AlSi₃O₁₀)F₂, and K tetrasilicic mica KMg_{2.5}(Si₄O₁₀)F₂; and swelling micas such as Na tetrasilicic mica NaMg_{2.5}(Si₄O₁₀)F₂, Na or Li teniolite (Na,Li)Mg₂Li(Si₄O₁₀)F₂, and montmorillonite-based Na or Li hectorite (Na,Li)_{1/8}Mg_{2/5}Li_{1/8}(Si₄O₁₀)F₂.

9. The planographic printing plate precursor according to claim 8, wherein the mica compound is a fluorine-containing swelling mica.

10. The planographic printing plate precursor according to claim 1, wherein the infrared absorbent is a dye or pigment having an absorption maximum at a wavelength of 750 to 1,400 nm.

11. The planographic printing plate precursor according to claim 1, wherein the coating amount of the protective layer is 0.1 to 2.0 g/m².

12. A method of making the planographic printing plate precursor according to claims 1, comprising:
placing a laminate of planographic printing plate precursors formed by laminating multiple layers of a protective layer on an aluminum plate, the rear surface of which is brought into contact with the surface of the protective layer in a plate setter,
conveying each of the planographic printing plate precursors automatically,
exposing the precursor with a light having a wavelength of 750 nm to 1,400 nm, and
developing the precursor practically without conducting heat treatment under the condition of a conveyance speed of 1.25 m/min or more.
